# EUROPEAN PATENT SPECIFICATION

(11) **EP 4 425 347 B1**
(45) Date of publication and mention of the grant of the patent: **29.10.2025**
(21) Application number: 24157063.9
(22) Date of filing: 12.02.2024
(51) Int. Cl.: G06F 13/16, G06F 13/38, G06F 13/40, H04L 67/565, G06F 3/06, H04L 69/08, H04L 69/18

(54) **NONVOLATILE MEMORY PACKAGE, STORAGE DEVICE INCLUDING THE SAME, AND METHOD OF OPERATING THE SAME**
NICHTFLÜCHTIGES SPEICHERPAKET, SPEICHERVORRICHTUNG DAMIT UND VERFAHREN ZUM BETRIEB DAVON
BOÎTIER DE MÉMOIRE NON VOLATILE, DISPOSITIF DE STOCKAGE LE COMPRENANT ET SON PROCÉDÉ DE FONCTIONNEMENT

(30) Priority: 02.03.2023 KR 20230027629
(43) Date of publication of application: 04.09.2024
(73) Proprietor: Samsung Electronics Co., Ltd., Suwon-si, Gyeonggi-do 16677 (KR)
(72) Inventor: KAVALA, Anil, 16677 Suwon-si, Gyeonggi-do (KR); KWON, Hyunjin, 16677 Suwon-si, Gyeonggi-do (KR); PARK, Jungjune, 16677 Suwon-si, Gyeonggi-do (KR); YOON, Chiweon, 16677 Suwon-si, Gyeonggi-do (KR); JO, Youngmin, 16677 Suwon-si, Gyeonggi-do (KR)
(74) Representative: Kuhnen & Wacker Patent- und Rechtsanwaltsbüro PartG mbB

(56) References cited:
- US-A1- 2014 082 260
- US-A1- 2019 138 440
- US-A1- 2022 172 753

## Description

### BACKGROUND

Example embodiments of the present disclosure relate to a nonvolatile memory package, a storage device including the same, and a method of operating the same.

Memory packages may include a plurality of memory chips mounted on a package substrate. A storage device may include at least one memory package. The storage device may include a controller for controlling the memory package. The controller may control a plurality of memory chips through a buffer chip included in the memory package. As a data storage space of various electronic devices has increased, demand for a memory package and a storage device in which buffer chips and memory chips are efficiently disposed has also increased.
US 2014/082260 A1 discloses a flash memory controller having dual mode pin-out.
US 2019/138440 A1 discloses a memory system and operating method thereof.
US 2022/172753 A1 discloses a memory device, memory system, and operating method of memory system.

### SUMMARY

The invention is set out in the appended set of claims.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a diagram of a storage device according to an example embodiment of the present disclosure;
FIG. 2 is a diagram of a first interface protocol and a second interface protocol according to an example embodiment of the present disclosure;
FIG. 3 is a diagram of a storage device according to an example embodiment of the present disclosure;
FIG. 4 is a diagram of a storage device according to an example embodiment of the present disclosure;
FIGS. 5A and 5B are diagrams illustrating interface protocols according to voltage levels of SCA/SCA_N pins;
FIG. 6 is a diagram of a storage device according to an example embodiment of the present disclosure;
FIG. 7 is a diagram of a storage device according to an example embodiment of the present disclosure;
FIG. 8 is a diagram of a storage device according to an example embodiment of the present disclosure;
FIG. 9 is a diagram of a storage device according to an example embodiment of the present disclosure;
FIG. 10 is a diagram of a storage device according to an example embodiment of the present disclosure;
FIG. 11 is a diagram of a storage device according to an example embodiment of the present disclosure;
FIG. 12 is a diagram of a storage device according to an example embodiment of the present disclosure;
FIG. 13 is a diagram of a storage device according to an example embodiment of the present disclosure;
FIG. 14 is a diagram of a nonvolatile memory device according to an example embodiment of the present disclosure;
FIG. 15 is a diagram of a controller according to an example embodiment of the present disclosure;
FIG. 16 is a diagram of a storage device according to an example embodiment of the present disclosure;
FIG. 17 is a diagram illustrating an example of a bidirectional CA pin operation of a NAND flash memory chip of a storage device of FIG. 16;
FIG. 18 is a diagram illustrating the timing of a legacy interface between a controller and a buffer chip in a storage device 1000 of FIG. 16;
FIG. 19 is a diagram illustrating the timing of an SCA interface between a buffer chip and a NAND chip in a storage device 1000 of FIG. 16;
FIG. 20 is a diagram of a storage device according to an example embodiment of the present disclosure;
FIG. 21 is a diagram illustrating an example of a bidirectional CA pin operation of a controller of a storage device of FIG. 20;
FIG. 22 is a diagram illustrating the timing of an SCA interface between a controller and a buffer chip in a storage device of FIG. 20;
FIG. 23 is a diagram illustrating the timing of a legacy interface between a buffer chip and a NAND chip in a storage device of FIG. 20;
FIG. 24 is a diagram of a storage device according to an example embodiment of the present disclosure;
FIG. 25 is a diagram of a storage device according to an example embodiment of the present disclosure;
FIGS. 26A and 26B are diagrams illustrating a method of operating an interface chip according to an example embodiment of the present disclosure;
FIGS. 27A and 27B are diagrams illustrating a method of operating an interface chip according to an example embodiment of the present disclosure;
FIGS. 28A and 28B are diagrams illustrating a method of operating an interface chip according to an example embodiment of the present disclosure;
FIG. 29 is a ladder diagram illustrating a program/erase operation of a storage device according to an example embodiment of the present disclosure;
FIGS. 30A and 30B are ladder diagrams illustrating a read operation of a storage device according to an example embodiment of the present disclosure;
FIG. 31 is a diagram of a nonvolatile memory device according to an example embodiment of the present disclosure.

### DETAILED DESCRIPTION

Hereinafter, embodiments of the present disclosure will be described below with reference to the accompanying drawings.

A nonvolatile memory package, and a storage device including the same may include an interface chip (or a buffer chip) having a bidirectional command address (CA) pin and a chip enable (CE) pin between different protocols (e.g. legacy protocol and new protocol; joint electron device engineering council (JEDEC) protocol and open NAND flash interface (ONFI) protocol), thereby improving protocol compatibility.

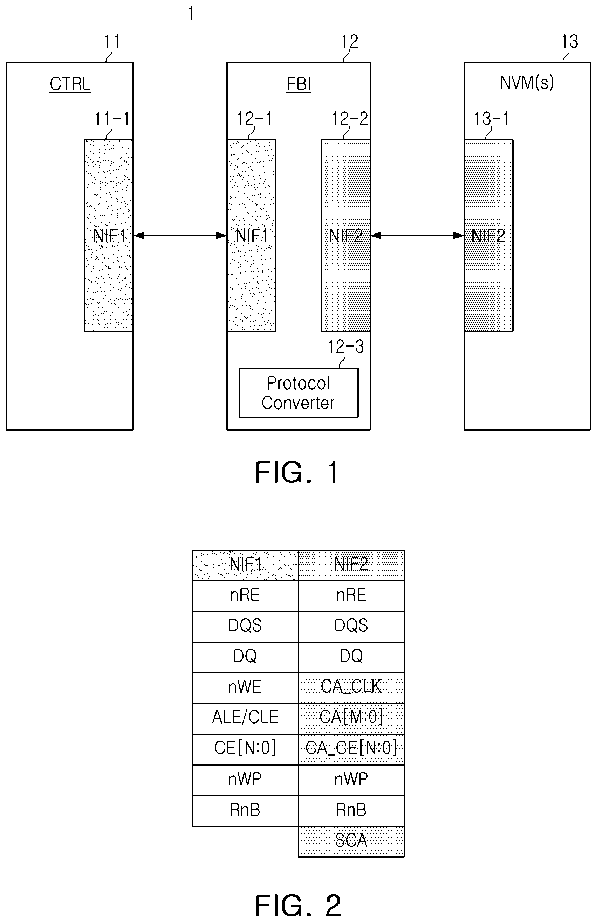

FIG. 1, which is not according to the invention, is a diagram of a storage device according to an example embodiment. Referring to FIG. 1, the storage device 1 may include a controller 11 (CTRL), an interface chip 12 (FBI) and at least one nonvolatile memory device 13 (NVM(s)). The interface chip 12 and at least one nonvolatile memory device 13 may be referred to as a nonvolatile memory package. In some embodiments, the interface chip 12 and the at least one nonvolatile memory device 13 may be put in a single package.

The controller 11 (CTRL) may be implemented to control overall operations of storage device 1. The controller 11 may include a first nonvolatile interface circuit 11-1. The first nonvolatile memory interface circuit 11-1 may be implemented to communicate with the interface chip 12 according to the first interface protocol NIF1. Here, the first interface protocol NIF1 may be configured as a NAND flash interface. In an example embodiment, the first nonvolatile memory interface protocol NIF1 may be configured as a first toggle interface supporting the JEDEC standard. In another example embodiment, the first nonvolatile memory interface protocol NIF1 may be configured as one of interfaces supporting the ONFI standard. However, it should be understood that the first interface protocol NIF1 in the example embodiment is not limited to the JEDEC/ONFI standard interface.

The interface chip 12 (FBI) may include a first nonvolatile memory interface circuit 12-1, a second nonvolatile memory interface circuit 12-2, and a protocol converter 12-3.

The first nonvolatile interface circuit 12-1 may be implemented to communicate with the first nonvolatile memory interface circuit 11-1 of the controller 11 according to the first interface protocol NIF1.

The second nonvolatile interface circuit 12-2 may be implemented to communicate with the second nonvolatile memory interface circuit 13-1 of at least one nonvolatile memory device 13 according to the second interface protocol NIF2. Here, the second interface protocol NIF2 may be different from the first interface protocol NIF 1 and may be configured as a NAND flash interface. In an example embodiment, the second interface protocol NIF2 may be configured as a second toggle interface supported by the JEDEC standard. Here, the second toggle interface may be configured as a higher version of the first toggle interface. In another example embodiment, the second nonvolatile memory interface protocol NIF2 may be configured as one of the interfaces supporting the ONFI standard. However, it should be understood that the second interface protocol NIF2 in the example embodiment is not limited to the JEDEC/ONFI standard interface.

The protocol converter 12-3 may be implemented to convert the first interface protocol NIF1 to the second interface protocol NIF2 or to convert the second interface protocol NIF2 to the first interface protocol NIF1. Here, the first interface protocol NIF1 may be configured as one of JEDEC/ONFI standard interfaces, and the first interface protocol NIF2 may be configured as one of JEDEC/ONFI standard interfaces.

In an example embodiment, the first interface protocol NIF1 may be configured as one of JEDEC standard interfaces, and the second interface protocol NIF2 may be configured as another one of JEDEC standard interfaces. In another example embodiment, the first interface protocol NIF1 may be configured as one of ONFI standard interfaces, and the second interface protocol NIF2 may be configured as another one of ONFI standard interfaces. In an example embodiment, the first interface protocol NIF1 may be configured as a JEDEC standard interface, and the second interface protocol NIF2 may be configured as an ONFI standard interface. In another example embodiment, the first interface protocol NIF 1 may be configured as an ONFI standard interface, and the second interface protocol NIF2 may be configured as a JEDEC standard interface. In the description below, the first interface protocol NIF1 and the second interface protocol NIF2 will be referred to as interfaces according to the JEDEC standard.

The storage device 1 according to the example embodiment may include an interface chip 12 supporting multi-protocol, such that products in various combinations may be implemented according to requirements of customers.

FIG. 2 is a diagram illustrating examples of a first interface protocol and a second interface protocol according to an example embodiment.

A device that operates under the first interface protocol NIF 1 may be provided with a read enable (nRE) pin, a data strobe signal (DQS) pin, a data (DQ) pin, a write enable (nWE) pin, a command latch enable (CLE) pin, an address latch enable (ALE) pin, a Chip Enable (CE[N:0]) pin, a write protect (nWP) pin, and a ready & busy (RnB) pin. For example, data transmission under the first interface protocol NIF1 may be performed through the DQ pin in synchronization with a DQS signal of the DQS pin, and a command and an address may be transmitted through the CLE pin and the ALE pin. In a data write operation, the nWE signal of the nWE pin may be activated, and in the data read operation, the nRE signal of the nRE pin may be activated. The RnB signal of the RnB pin may indicate whether the at least one NAND memory device 13 is operating, and the operation of the NAND memory device 13 may be activated through the nCE signal of the nCE pin.

A device that operates under the second interface protocol NIF2 may be provided with an nRE pin, a DQS pin, DQ, a CA_CLK pin, a CA[M:0] pin, a CA_CE[N:0]) pin, an nWP pin, a RnB pin, and an SCA pin. Under the second interface protocol NIF2, the CA_CLK pin, the CA[M:0] pin, and the CA _CE[N:0] pin are assigned for separately transmitting a command/address. An SCA signal of the SCA pin may indicate whether the second interface protocol NIF2 is activated. For example, the high level SCA signal may indicate activation of the second interface protocol NIF2, and the low level SCA signal may indicate deactivation of the second interface protocol NIF2. In an example embodiment, CA_CLK pin or CA_CE[N:0] pin may support bi-direction communication.

The storage device 1 of FIG. 1 may communicate between the controller CTRL and the interface chip FBI according to the first interface protocol NIF1 and may communicate according to the second interface protocol NIF2 between the interface chip FBI and the nonvolatile memory device NVM(s). However, the storage device in the example embodiment is not limited thereto. The storage device in the example embodiment may communicate according to the second interface protocol NIF2 between the controller CTRL and the interface chip FBI and may communicate according to the first interface protocol NIF1 between the interface chip FBI and the nonvolatile memory device NVM(s).

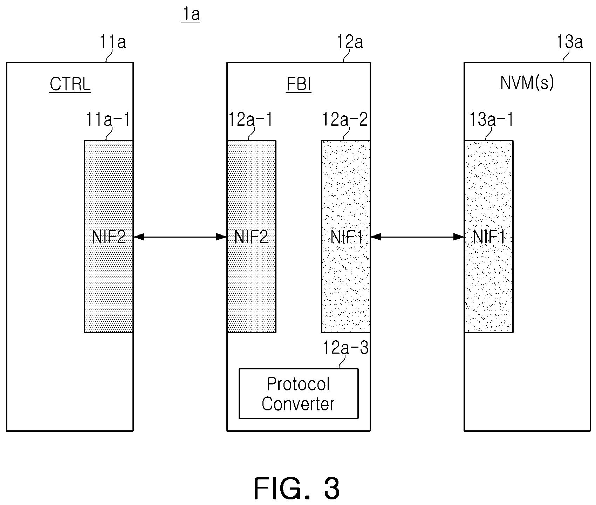

FIG. 3 is a diagram of a storage device according to an example embodiment. Referring to FIG. 3, a storage device 1a includes a controller 11a, an interface chip 12a and at least one nonvolatile memory device 13a. The interface chip 12a of FIG. 3 includes a first nonvolatile memory interface circuit 12a-1, a second nonvolatile memory interface circuit 12a-2, and a protocol converter 12a-3. The first nonvolatile interface circuit 12a-1 may be implemented to communicate with a nonvolatile interface circuit 11a-1 of the controller 11a according to the second interface protocol NIF2. The second nonvolatile interface circuit 12a-2 may be implemented to communicate with a nonvolatile interface circuit 13a-1 of at least one nonvolatile memory device 13a according to the first interface protocol NIF1.

In the storage device according to the example embodiment, one of first interface protocol NIF1 and the second interface protocol NIF2 is determined according to a voltage state of the SCA pin. For example, the first nonvolatile memory interface circuit 12a-1 selects one of the first interface protocol NIF1 and the second interface protocol NIF2 according to the voltage level of the SCA signal of the SCA pin.

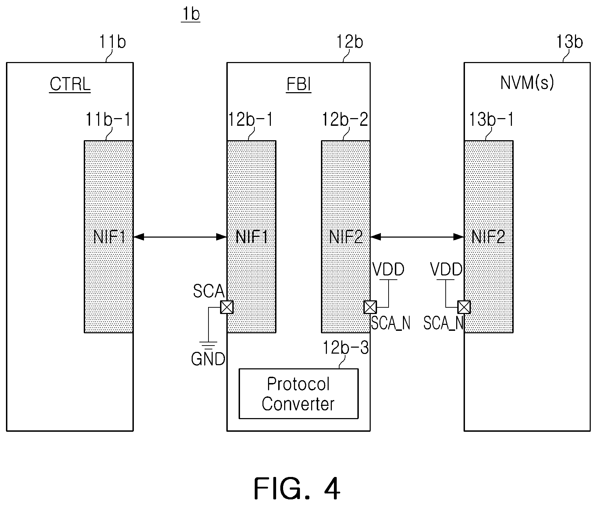

FIG. 4 is a diagram of a storage device 1b according to an example embodiment. Referring to FIG. 4, the storage device 1b includes a controller 11b, an interface chip 12b and at least one nonvolatile memory device 13b. The interface chip 12b of FIG. 4 includes a first nonvolatile memory interface circuit 12b-1, a second nonvolatile memory interface circuit 12b-2, and a protocol converter 12b-3. The first nonvolatile interface circuit 12b-1 may be implemented to communicate with the first nonvolatile interface circuit 11b-1 of the controller 11b according to the first interface protocol NIF1. As illustrated in FIG. 4, the first nonvolatile interface circuit 12b-1 may include a first protocol conversion activation pin SCA connected to a ground terminal GND. The second nonvolatile interface circuit 12b-2 may be implemented to communicate with the second nonvolatile interface circuit 13b-1 of at least one nonvolatile memory device 13b according to the second interface protocol NIF2. As illustrated in FIG. 4, the second nonvolatile interface circuit 12b-2 may include a second protocol conversion activation pin SCA_N connected to a power terminal VDD.

At least one nonvolatile memory device 13b may include a second nonvolatile interface circuit 13b-1. As illustrated in FIG. 4, the second nonvolatile interface circuit 13b-1 may include a protocol conversion activation pin SCA_N connected to a power terminal VDD.

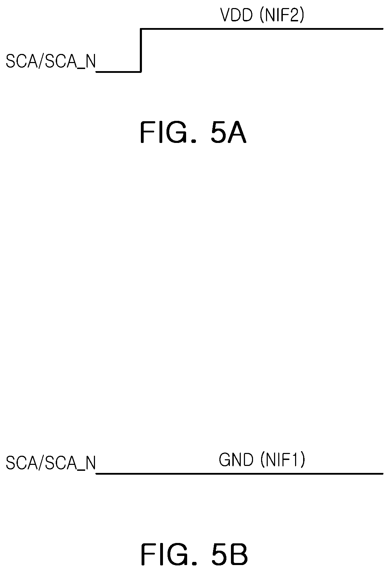

FIGS. 5A and 5B are diagrams illustrating interface protocols according to voltage levels of SCA/SCA_N pins. As illustrated in FIG. 5A, when a voltage level of the SCA/SCA_N pin is a high level (e.g., a power voltage applied to the power terminal VDD), the interface protocol may instruct the second interface protocol NIF2. As illustrated in FIG. 5B, when the voltage level of the SCA/SCA_N pin is a low level (e.g., a ground voltage applied to the ground terminal GND), the interface protocol may instruct the first interface protocol NIF1. For example, when the voltage level of a signal of the SCA/SCA_N pin is a high level (e.g., a power voltage applied to the power terminal VDD), each of the nonvolatile memory interface circuit 13b-1 and first and second nonvolatile memory interface circuits 12b-1 and 12b-2 may operate according to the second interface protocol NIF2, and when the voltage level of the signal of the SCA/SCA_N pin is a low level (e.g., a ground voltage applied to the ground terminal GND), each of the nonvolatile memory interface circuit 13b-1 and first and second nonvolatile memory interface circuits 12b-1 and 12b-2 may operate according to the first interface protocol NIF1. In an embodiment, each of the nonvolatile memory interface circuit 13b-1 and first and second nonvolatile memory interface circuits 12b-1 and 12b-2 may be provided with the SCA/SCA_N pin that is biased with one of a high voltage level (e.g., a power voltage applied to the power terminal VDD) and a low voltage level (e.g., a ground voltage applied to the ground terminal GND) to select one of the first and second interface protocols NIF1 and NIF2. In an embodiment, the SCA/SCA_N pin may be a dedicated pin for protocol selection or may be a shared pin for another function in addition to the protocol selection.

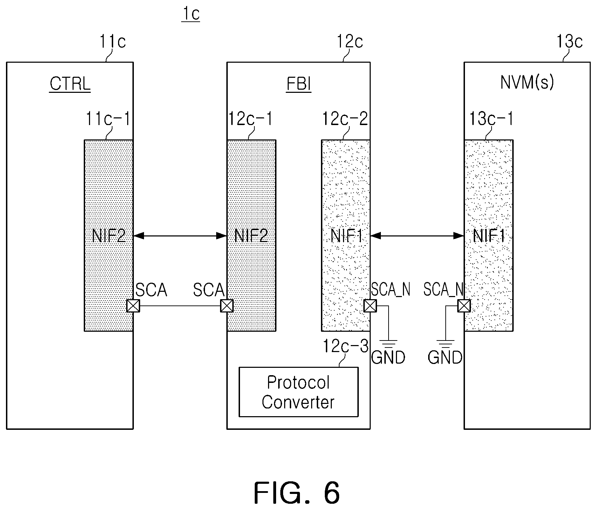

FIG. 6 is a diagram of a storage device 1c according to an example embodiment. Referring to FIG. 6, the storage device 1c includes a controller 11c, an interface chip 12c and at least one nonvolatile memory device 13c.

The controller 1c may include a nonvolatile interface circuit 11c-1 having a protocol conversion activation pin SCA. The interface chip 12c includes a first nonvolatile memory interface circuit 12c-1 having a first protocol conversion activation pin SCA, a second nonvolatile memory interface circuit 12c-2 having a second protocol conversion activation pin SCA_N, and a protocol converter 12c-3. As illustrated in an example embodiment, FIG. 6, the protocol conversion activation pin SCA of the controller 11c and the first protocol conversion activation pin SCA of the interface chip 12c may be connected with each other. In an example embodiment, the second protocol conversion activation pin SCA_N of the interface chip 12c may be connected to a ground terminal GND. At least one nonvolatile memory device 13c may include a nonvolatile interface circuit 13c-1 having a protocol conversion activation pin SCA_N connected to the ground terminal GND.

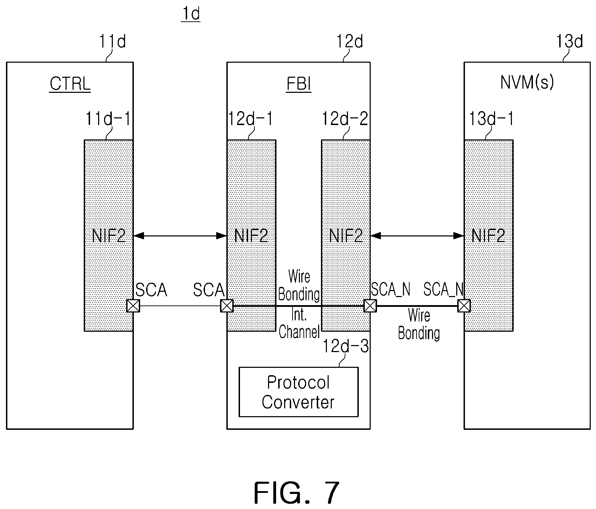

FIG. 7 is a diagram of a storage device 1d according to an example embodiment. Referring to FIG. 7, a storage device 1d includes a controller 11d, an interface chip 12d and at least one nonvolatile memory device 13d.

The storage device 1d includes an interface chip 12d. The interface chip 12d includes a first nonvolatile memory interface circuit 12d-1 having a first protocol conversion activation pin SCA, a second nonvolatile memory interface circuit 12d-2 having a second protocol conversion activation pin SCA_N, and a protocol converter 12d-3. The first protocol conversion activation pin SCA of the first nonvolatile memory interface circuit 12d-1 and a second protocol conversion activation pin SCA_N of the second nonvolatile memory interface circuit 12d-2 may be connected with each other through wire bonding or internal channel, as compared to the storage device 1c of FIG. 6. In an example embodiment, the second protocol conversion activation pin SCA_N of the interface chip 12d and a protocol conversion activation pin SCA_N of at least one nonvolatile memory device 13d may be connected with each other by wire bonding as illustrated in FIG. 7.

In an example embodiment, the first nonvolatile memory interface circuit 12d-1 of the interface chip 12d may be connected to a nonvolatile memory interface circuit 11d-1 of the controller 11d according to the second interface protocol NIF2. In an example embodiment, the second nonvolatile memory interface circuit 12d-2 of the interface chip 12d may be connected to a nonvolatile memory interface circuit 13d-1 of at least one nonvolatile memory device 13d according to the second interface protocol NIF2.

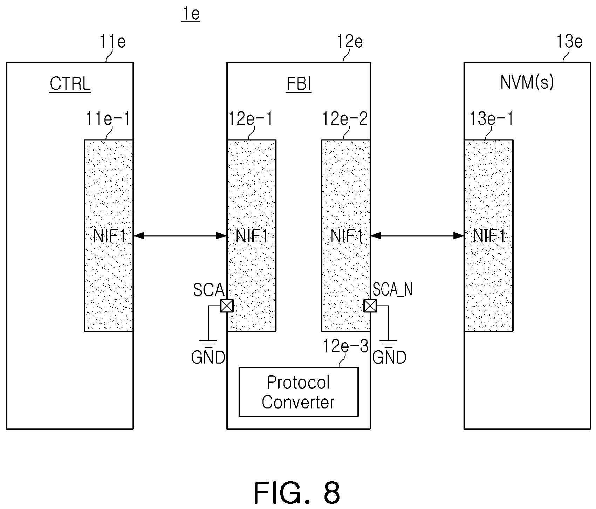

FIG. 8 is a diagram of a storage device 1e according to an example embodiment. Referring to FIG. 8, the storage device le includes a controller 11e, an interface chip 12e and at least one nonvolatile memory device 13e. As illustrated in FIG. 8, the interface chip 12e may include a first nonvolatile memory interface circuit 12e-1 having a first protocol conversion activation pin SCA connected to the ground terminal GND, a second nonvolatile memory interface circuit 12e-2 having a second protocol conversion activation pin SCA_N connected to the ground terminal GND, and a protocol converter 12e-3.

In an example embodiment, the first nonvolatile memory interface circuit 12e-1 of the interface chip 12e is connected to a nonvolatile memory interface circuit 11e-1 of the controller 11e. The interface chip 12e and the controller 11e may communicate with each other according to the first interface protocol NIF1. In an example embodiment, the second nonvolatile memory interface circuit 12e-2 of the interface chip 12e is connected to a nonvolatile memory interface circuit 13e-1 of at least one nonvolatile memory device 13e. The at least nonvolatile memory device 13e and the interface chip 12 may communicate with each other according to the first interface protocol NIF1.

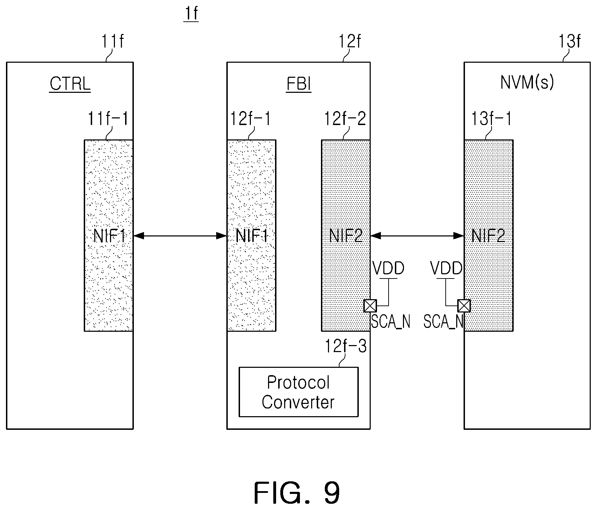

FIG. 9, which is not according to the invention, is a diagram of a storage device 1f according to an example embodiment. Referring to FIG. 9, the storage device 1f may include a controller 11f, an interface chip 12f and at least one nonvolatile memory device 13f. The interface chip 12f may include a first nonvolatile memory interface circuit 12f-1, a second nonvolatile memory interface circuit 12f-2 having a second protocol conversion activation pin SCA_N connected to a power terminal VDD, and a protocol converter 12f-3.

In an example embodiment, the first nonvolatile memory interface circuit 12f-1 of the interface chip 12f may be connected to a nonvolatile memory interface circuit 11f-1 of the controller 11f. The controller 11f and the interface chip 12f may communicate with each other according to the first interface protocol NIF1. In an example embodiment, the second nonvolatile memory interface circuit 12f-2 of the interface chip 12f may be connected to a nonvolatile memory interface circuit 13f-1 of at least one nonvolatile memory device 13f. The interface chip 12f and the at least one nonvolatile memory device 13f may communicate with each other according to the second interface protocol NIF2.

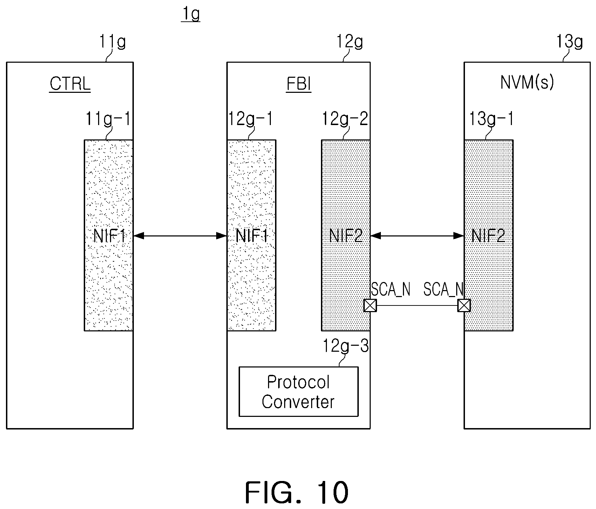

FIG. 10, which is not according to the invention, is a diagram of a storage device 1g according to an example embodiment. Referring to FIG. 10, the storage device 1g may include a controller 11g, an interface chip 12g and at least one nonvolatile memory device 13g. The interface chip 12g may include a first nonvolatile memory interface circuit 12g-1, a second nonvolatile memory interface circuit 12g-2 having a second protocol conversion activation pin SCA_N, and a protocol converter 12g-3.

In an example embodiment, the first nonvolatile memory interface circuit 12g-1 of the interface chip 12g may be connected to a nonvolatile memory interface circuit 11g-1 of the controller 11g. The interface chip 12g and the controller 11g may communicate with each other according to the first interface protocol NIF1. In an example embodiment, the second nonvolatile memory interface circuit 12g-2 of the interface chip 12g may be connected to a nonvolatile memory interface circuit 13g-1 of at least one nonvolatile memory device 13g. The interface chip 12g and the at least one nonvolatile memory device 13g may communicate with each other according to the second interface protocol NIF2.

In an example embodiment, the second protocol conversion activation pin SCA_N of the second nonvolatile memory interface chip 12g-2 and a protocol conversion activation pin SCA_N of at least one nonvolatile memory device 13g may be connected with each other as illustrated in FIG. 10. The protocol converter 12g-3 may be connected to the second protocol conversion activation pin SCA_N of the interface chip 12g. The protocol converter 12g-3 may provide a voltage level (e.g., one of a high voltage level such as a power voltage applied to the power terminal VDD and a low level such as a ground voltage applied to the ground terminal GND) with the second protocol conversion activation pin SCA_N. Accordingly, the pin SCA_N of each of the interface chip 12g and at least one nonvolatile memory device 13g may not have a floating state.

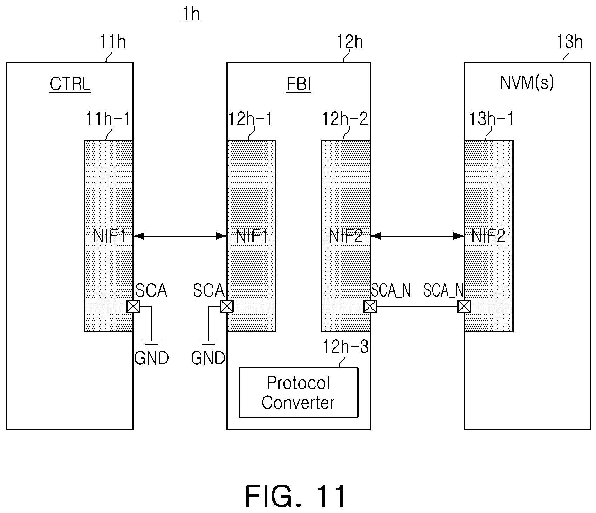

FIG. 11 is a diagram of a storage device 1h according to an example embodiment. Referring to FIG. 11, a storage device 1h includes a controller 11h, an interface chip 12h and at least one nonvolatile memory device 13h. The interface chip 12h may include a first nonvolatile memory interface circuit 12h-1 having a first protocol conversion activation pin SCA connected to the ground terminal GND, a second nonvolatile memory interface circuit 12h-2 having a second protocol conversion activation pin SCA_N, and a protocol converter 12h-3.

In an example embodiment, the first nonvolatile memory interface circuit 12h-1 of the interface chip 12h is connected to a nonvolatile memory interface circuit 11h-1 of the controller 11h. The interface chip 12h and the controller 11h may communicate with each other according to the first interface protocol NIF1. The nonvolatile memory interface circuit 11h-1 of the controller 11h may have a protocol conversion activation pin SCA connected to the ground terminal GND. In an example embodiment, the second nonvolatile memory interface circuit 12h-2 of the interface chip 12h is connected to a nonvolatile memory interface circuit 13h-1 of at least one nonvolatile memory device 13h. The interface chip 12h and the at least one nonvolatile memory device 13h may communicate with each other according to the second interface protocol NIF2.

In an example embodiment, the second protocol conversion activation pin SCA_N of the interface chip 12h and a protocol conversion activation pin SCA_N of at least one nonvolatile memory device 13h may be connected with each other as illustrated in FIG. 11. The protocol converter 12h-3 may be connected to the second protocol conversion activation pin SCA_N of the interface chip 12h. The protocol converter 12h-3 may provide a voltage level (e.g., one of a high voltage level such as VDD and a low level such as a ground voltage applied to the ground terminal GND) with the second protocol conversion activation pin SCA_N of the interface chip 12h. Accordingly, the second protocol conversion activation pin SCA_N of the interface chip and the protocol conversion activation pin SCA_N of the at least one nonvolatile memory device 13h may not have a floating state.

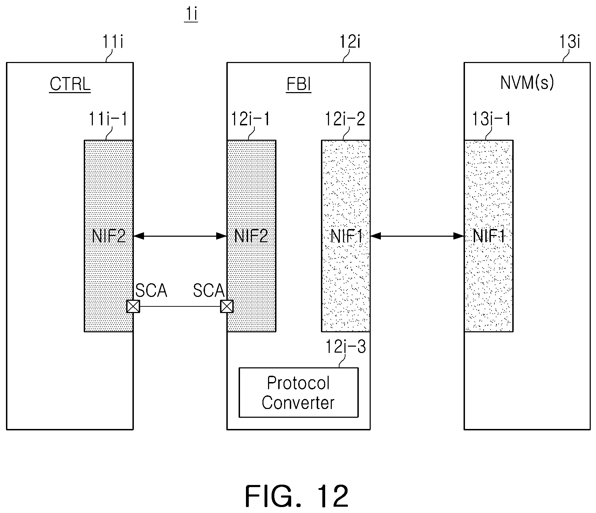

FIG. 12 is a diagram of a storage device 1i according to an example embodiment. Referring to FIG. 12, which is not according to the invention, the storage device 1i may include a controller 11i, an interface chip 12i and at least one nonvolatile memory device 13i. The interface chip 12i may include a first nonvolatile memory interface circuit 12i-1 having a first protocol conversion activation pin SCA, a second nonvolatile memory interface circuit 12i-2, and a protocol converter 12i-3.

In an example embodiment, the first nonvolatile memory interface circuit 12i-1 of the interface chip 12i may be connected to a nonvolatile memory interface circuit 11i-1 of the controller 11i. The interface chip 12i and the controller 111i may communicate with each other according to the second interface protocol NIF2. The nonvolatile memory interface circuit 11i-1 of the controller 11i may have a protocol conversion activation pin SCA. In an example embodiment, the protocol conversion activation pin SCA of the controller 11i may be connected to the first protocol conversion activation pin SCA of the interface chip 12i as illustrated in FIG. 12.

In an example embodiment, the second nonvolatile memory interface circuit 12i-2 of the interface chip 12i may be connected to a nonvolatile memory interface circuit 13i-1 of at least one nonvolatile memory device 13i. The interface chip 12i and the at least one nonvolatile memory device 13i may communicate with each other according to the first interface protocol NIF1.

The interface chip FBI and at least one nonvolatile memory device NVM(s) according to the example embodiment may be implemented as a nonvolatile memory package. In some embodiments, the interface chip 12i and the at least one nonvolatile memory device 13i may be put in a single package.

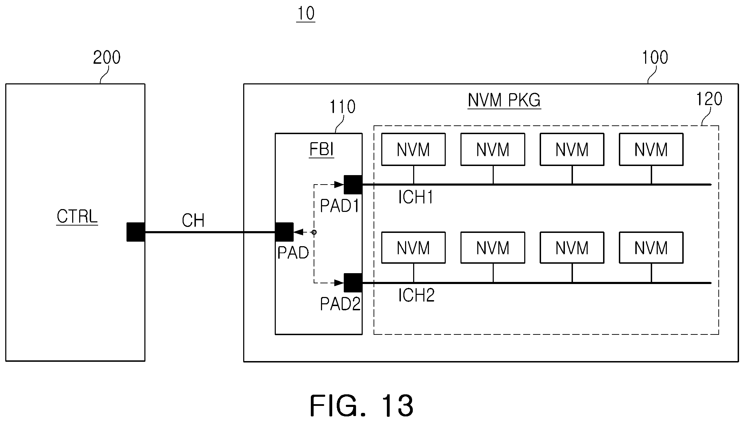

FIG. 13 is a diagram of a storage device 10 according to an example embodiment. Referring to FIG. 13, the storage device 10 may include a nonvolatile memory package 100 (NVM PKG), and a controller 200 (CTRL) controlling the nonvolatile memory package 100.

The nonvolatile memory package 100 (NVM PKG) may include an interface chip 110 (a frequency boosting interface chip (FBI) or a "buffer chip"), and a plurality of nonvolatile memory devices 120 (NVMs) connected to internal channels ICH1 and ICH2. The number of internal channels ICH1 and ICH2 as illustrated in FIG. 1 may be 2, but the number of internal channels in the example embodiment is not limited thereto.

The interface chip 110 (FBI) may be connected to the controller 200 through a channel CH. The channel CH1 may be connected to a first internal channel ICH1 and/or a second internal channel ICH2 through the interface chip 110. The interface chip 110 may include a retraining check circuit for internally determining the need for retraining. The retraining check circuit may be implemented to determine the need for retraining using a non-selected channel among internal channels ICH1 and ICH2. In an example embodiment, the retraining check circuit may include a built-in self-test (BIST) circuit, an oscillator, or a delayed locked loop (DLL) circuit.

The interface chip 110 may include a plurality of pads PAD connected to the channel CH. The interface chip 110 may include first pads PAD1 connected between the plurality of pads PAD and the first internal channel ICH1 and second pads PAD2 connected between the plurality of pads PAD and the second internal channel ICH2. For example, the first pads PAD 1 may connect the pads PAD to the first internal channel ICH1, and the second pads PAD2 may connect the pads PAD to the second internal channel ICH2. In some embodiments, when the interface chip 12 of FIG. 1 is applied to the interface chip 110 of FIG. 13, the pads PAD may be connected to the first nonvolatile interface circuit 12-1, and the first and second pads PAD1 an PAD2 may be connected to the second nonvolatile interface circuit 12-2.

The interface chip 110 may be implemented as the interface chip described with reference to FIGS. 1 to 12. The interface chip 110 may implement an interface protocol for communicating with the controller 200 and an interface protocol for communicating with the nonvolatile memory devices 120 in a compatible manner. For example, the interface chip 110 may communicate with the controller 200 according to the first interface protocol NIF1 and may communicate with each of the nonvolatile memory devices 120 according to the second interface protocol NIF2. Alternatively, the interface chip 110 may communicate with the controller 200 according to the second interface protocol NIF2 and may communicate with each of the nonvolatile memory devices 120 according to the first interface protocol NIF1.

The interface chip 110 may be implemented to convert an interface protocol by sensing a voltage level of a signal applied to a special pin (e.g., a SCA/SCA_N pin).

Each of the nonvolatile memory devices 120 (NVMs) may be implemented to store data. A plurality of nonvolatile memory devices may be connected to each of the internal channels ICH1 and ICH2. In FIG. 13, four nonvolatile memory devices are connected to each of the internal channels ICH1 and ICH2, but the number of nonvolatile memory devices connected to the internal channels ICH1 and ICH2 in the example embodiment is not limited thereto. In an example embodiment, in the nonvolatile memory package 100, the nonvolatile memory devices 120 (memory chips) may be stacked in a vertical direction.

The controller 200 (CTRL) may be implemented to control overall operations of the nonvolatile memory package 100. The controller 200 may perform functions necessary for data management of the nonvolatile memory package 100, such as address mapping, error correction, garbage collection, wear-leveling, bad block management, and data correction. These functions may be implemented using hardware, software, or firmware.

The controller 200 may receive a retraining request received from the nonvolatile memory package 100, may issue a retraining command, and may transmit the retraining command to the nonvolatile memory package 100. Accordingly, the nonvolatile memory package 100 may perform a retraining operation corresponding to the non-selected channel.

The storage device 10 according to the example embodiment may include an interface chip 110 supporting multi-protocol communication, thereby enabling bidirectional CA (command/address) interface conversion of the controller 200 and the nonvolatile memory devices 120 using a bidirectional CA interface converter. The storage device 10 according to the example embodiment may include a nonvolatile memory package NVM_PKG for performing communication according to different interface protocols between the external channel CH and the internal channels ICH1 and ICH2, such that interoperability of the nonvolatile memory products of different generations or nonvolatile memory interface protocols of different generations may be secured.

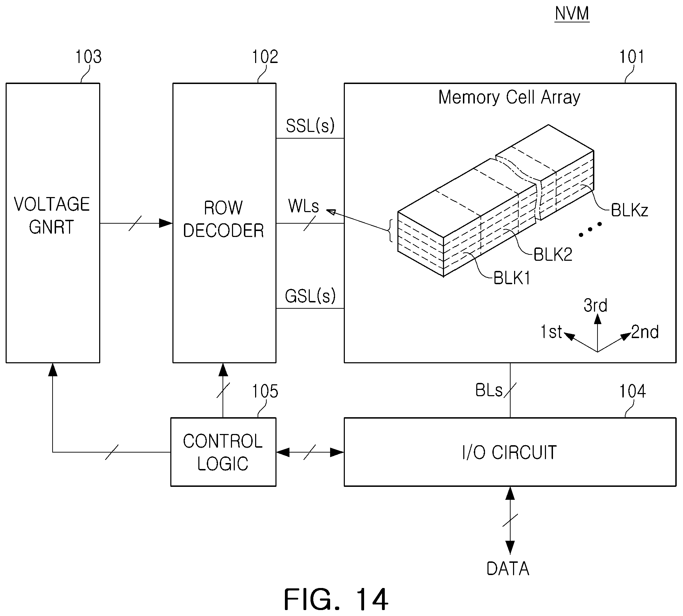

FIG. 14 is a diagram of a nonvolatile memory device NVM according to an example embodiment. Referring to FIG. 14, the nonvolatile memory device NVM may include a memory cell array 101, an address decoder 102, a voltage generator circuit 103, an input/output circuit 104 and a control logic 105.

The nonvolatile memory device NVM may be implemented as a NAND flash memory, vertical NAND flash memory (Vertical NAND; VNAND), NOR flash memory, resistive random access memory (RRAM), phase-change memory (PRAM), magnetoresistive random access memory (MRAM), ferroelectric random access memory (FRAM), or spin transfer torque random access memory (STT-RAM). For ease of description, the nonvolatile memory device NVM may be referred to as a vertical NAND flash memory device below.

The memory cell array 101 may include a plurality of memory blocks BLK1 to BLKz. Each of the memory blocks BLK1 to BLKz may be connected to the address decoder 102 via wordlines WLs, at least one string selection line SSL and at least one ground selection line GSL. The memory cell array 101 may be connected to the input/output circuit 124 via bitlines BLs. In an example embodiment, wordlines WLs may have a stacked plate-shaped structure.

Each of the plurality of memory blocks BLK1 to BLKz may be disposed in the first and second directions (different from the first direction) on the substrate, and may include a plurality of strings of a three-dimensional structure disposed in the third direction (direction perpendicular to a plane formed in the first and second directions). Each of the plurality of strings may include at least one string selection transistor, a plurality of memory cells, and at least one ground selection transistor connected in series between a bitline and a common source line CSL. Each of the plurality of memory cells may be implemented to store at least one bit in a region in which wordlines WLs and bitlines BLs intersect with each other. In an example embodiment, a plurality of memory cells may be disposed between at least one string selection transistor and at least one dummy cell. In an example embodiment, at least one dummy cell may be disposed between the plurality of memory cells and at least one ground selection transistor.

The address decoder 102 may be implemented to select one of a plurality of memory blocks BLK1 to BLKz in response to an address. The address decoder 102 may be connected to the memory cell array 101 through wordlines WLs, at least one string selection line SSL and at least one ground selection line GSL. The address decoder 102 may select wordlines WLs, a string selection line SSL, and a ground selection line GSL using the decoded row address. The address decoder 102 may decode a column address among input addresses. The decoded column address may be transmitted to the input/output circuit 104. In an example embodiment, the address decoder 102 may include a row decoder, a column decoder, and an address buffer.

The voltage generator circuit 103 may be implemented to generate voltages (program voltage, pass voltage, read voltage, read pass voltage, verify voltage, erase voltage, common source line voltage, and well voltage) required for operation. The voltage generator circuit 103 may generate wordline voltages required for program/read/erase operations.

The input/output circuit 104 may be connected to the memory cell array 101 through bitlines BLs. The input/output circuit 104 will be implemented to receive the decoded column address from the address decoder 102. The input/output circuit 104 may select bitlines BLs using the decoded column address. The input/output circuit 104 may include a plurality of page buffers to store data to be programmed during a program operation or to store read data during a read operation. Each of the plurality of page buffers may include a plurality of latches. During a program operation, the data stored in the page buffers may be programmed into a page of the selected memory block through bitlines BLs. During a read operation, data read from the page of the selected memory block may be stored in page buffers through bitlines BLs. The input/output circuit 104 may read data from the first region of the memory cell array 101 and may store the read data in the second region of the memory cell array 101. For example, the input/output circuit 104 may be implemented to perform a copy-back operation.

The control logic 105 may be implemented to control overall operations (program/read/erase) of the nonvolatile memory device NVM. The control logic 105 may operate in response to control signals or commands input from an external entity.

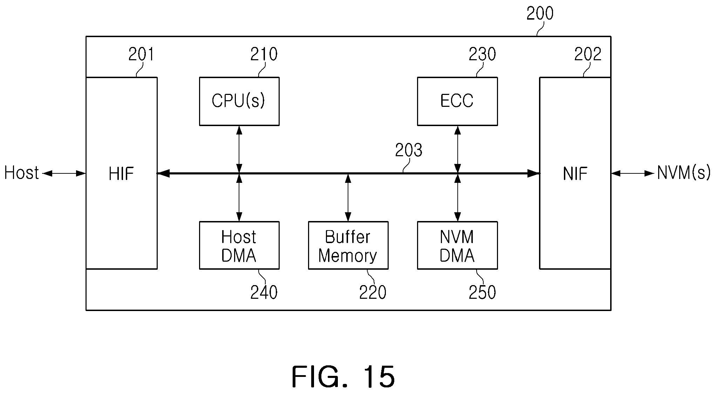

FIG. 15 is a diagram of a controller 200 according to an example embodiment. Referring to FIG. 15, the controller 200 may include a host interface circuit 201 (HIF), a nonvolatile memory interface circuit 202 (NIF), a bus 203, at least one processor 210 (CPU(s)), a buffer memory 220, an error correction circuit 230 (ECC), a host direct memory access (DMA) circuit 240 and a nonvolatile memory DMA circuit 250.

The host interface circuit 201 (HIF) may be implemented to transmit a packet to and receive a packet from a host. A packet transmitted from the host to the host interface circuit 201 may include a command or data to be written to the nonvolatile memory device NVM. A packet transmitted from the host interface circuit 201 to the host may include a response to a command or data read from the nonvolatile memory device NVM.

The nonvolatile memory interface circuit 202 (NIF) may transmit data to be written to the nonvolatile memory device NVM to the nonvolatile memory device NVM or to receive data read from the nonvolatile memory device NVM. The nonvolatile memory interface circuit 202 may be implemented to comply with standard protocols such as JEDEC or ONFI.

At least one processor 210 may be implemented to control overall operations of the storage device 12. The processor 210 may perform various management such as cache/buffer management, firmware management, garbage collection management, wear leveling management, data deduplication management, read refresh/reclaim management, bad block management, multi-stream management, mapping management between host data and nonvolatile memory, quality of service (QoS) management, system resource allocation management, nonvolatile memory queue management, read level management, erase/program management, hot/cold data management, power loss protection management, dynamic thermal management, initialization management, and redundant array of inexpensive disk (RAID). These management operations may be implemented using hardware, firmware, or software.

The buffer memory 220 may temporarily store data to be written to the nonvolatile memory device NVM or data read from the nonvolatile memory device NVM. In an example embodiment, the buffer memory 220 may be configured as a component included in the controller 200. In an example embodiment, the buffer memory 220 may be disposed outside the controller 200. The buffer memory 220 may be implemented as a volatile memory (e.g., static random access memory (SRAM), dynamic RAM (DRAM), synchronous RAM (SDRAM), or the like) or a nonvolatile memory (flash memory, phase-change RAM (PRAM), magneto-resistive RAM (MRAM), resistive RAM (ReRAM), ferro-electric RAM (FRAM), or the like).

The error correction circuit 230 (ECC) may be implemented to generate an error correction code during a program operation and to recover data using the error correction code during a read operation. For example, the error correction circuit 230 may generate an error correction code for correcting a fail bit or error bit of data received from the nonvolatile memory device NVM. The error correction circuit 230 may form data to which parity bits are added by performing error correction encoding of data provided to the nonvolatile memory device NVM. The parity bits may be stored in the nonvolatile memory device NVM.

The error correction circuit 230 may perform error correction decoding on data output from the nonvolatile memory device NVM. The error correction circuit 230 may correct errors using a parity. The error correction circuit 230 may correct an error using a low density parity check (LDPC) code, BCH code, turbo code, Reed-Solomon code, convolution code, recursive systematic code (RSC), and coded modulation such as trellis-coded modulation (TCM), or block coded modulation (BCM). Meanwhile, when error correction is impossible in the error correction circuit 230, a read retry operation may be performed.

The packet manager may generate a packet according to a protocol of an interface negotiated with a host or may parse various types of information from a packet received from the host. The encryption device may perform at least one of an encryption operation and a decryption operation on data input to the controller 200 using a symmetric-key algorithm. The encryption device may perform encryption and decryption of data using advanced encryption standard (AES) algorithm. An encryption device may include an encryption module and a decryption module. In an example embodiment, an encryption device may be implemented using hardware, software, or firmware. The encryption device may perform a self-encryption disk (SED) function or a trusted computing group (TCG) security function. The SED function may store encrypted data in a nonvolatile memory device NVM using an encryption algorithm or may decrypt encrypted data from the nonvolatile memory device NVM. The encryption/decryption operation may be performed using an internally generated encryption key. The TCG security function may provide a mechanism enabling control over access to user data of the storage device 10. For example, the TCG security function may perform an authentication procedure between an external device and the storage device 10. In an example embodiment, one of the SED function and TCG security function may be selected.

The host DMA circuit 240 may be implemented to control DMA operation between the host device and the controller 200. The host DMA circuit 240 may perform an operation of storing data input from a host device through the host interface circuit 201 in the buffer memory 220 during a program operation under the control of the host controller. The host DMA circuit 240 may perform an operation of outputting data stored in the buffer memory 220 to the host device through the host interface circuit 201 during a read operation. In an example embodiment, the host DMA circuit 240 may be implemented to be included in the host controller as a component of the host controller.

The nonvolatile memory DMA circuit 250 may be implemented to control a DMA operation between the controller 200 and the nonvolatile memory device NVM. The nonvolatile memory DMA circuit 250 may perform an operation of outputting data stored in the buffer memory 220 to the nonvolatile memory device NVM through the nonvolatile memory interface circuit 202 during a program operation under the control of a nonvolatile memory controller. The nonvolatile memory DMA circuit 250 may perform an operation of reading data stored in the nonvolatile memory device NVM through the nonvolatile memory interface circuit 202 during a read operation.

The nonvolatile memory DMA circuit 250 may receive at least one data group divided into read transmission units from the nonvolatile memory interface circuit 202 during a read operation. The nonvolatile memory DMA circuit 250 may divide each data group into at least two data sub-groups having a smaller data size unit than the read transmission unit. The divided data sub-groups may be data of which an error has been corrected in the error correction circuit 230. In an example embodiment, when a first read pass is selected, at least two divided data sub-groups may be transmitted to the host DMA circuit 240. In an example embodiment, when the second read pass is selected, at least two divided data sub-groups may be transmitted to the buffer memory 220.

When data sub-groups are transmitted to the buffer memory 220, the nonvolatile memory DMA circuit 250 may output information indicating the start of read streaming to the buffer controller. For example, the nonvolatile memory DMA circuit 250 may be implemented to be included in the nonvolatile memory controller as a component of the nonvolatile memory controller.

The first interface protocol NIF1 in the example embodiment may be configured as a legacy protocol among NAND flash interface protocols for each generation, and the second interface protocol NIF2 may be configured as a new protocol, for example, a separate command address (SCA) protocol. The first NAND Flash Drive Interface is referred to as the legacy protocol, which is configured to utilize the asynchronous data transfer scheme.

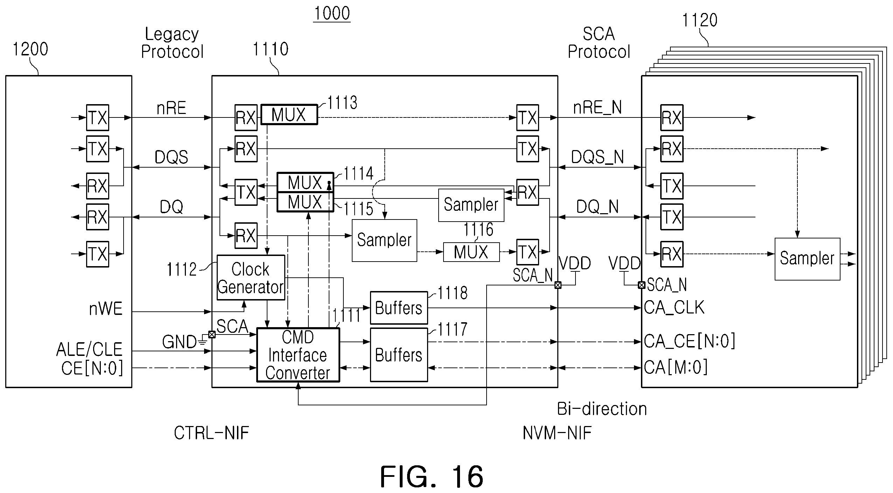

FIG. 16 is a diagram of a storage device 1000 according to an example embodiment. Referring to FIG. 16, a storage device 1000 may include a buffer chip 1110, a plurality of NAND flash memory chips 1120, and a controller 1200.

The buffer chip 1110 may be implemented to work as a command interface converter between the legacy protocol and the SCA protocol. For example, the buffer chip 1110 may be implemented to communicate with each of the plurality of NAND flash memory chips 1120 according to the SCA protocol and to communicate with the controller 1200 according to the legacy protocol.

The buffer chip 1110 may include a command interface converter 1111, a clock generator 1112, multiplexers 1113, 1114, 1115, and 1116, and buffers 1117 and 1118. The command interface converter 1111 may correspond to the protocol converters 12-3 and 12a-3 to 12i-3.

The command interface converter 1111 may receive a legacy protocol command (DQ/ALE/CLE/CE) from the controller 1200, may convert the received legacy protocol command (DQ/ALE/CLE/CE) to an SCA protocol command, and may output the SCA protocol command corresponding to the legacy protocol command to the NAND flash memory chip 1120 through CA_CE and CA pins. For example, during a command write operation, the command interface converter 1111 may receive signals ALE, CLE, CE[N:0], nWE, and DQ of the legacy protocol command, and may covert the received signals to signals CA_CLK CA[M:0], and CA_CE[N:0] of the SCA protocol command. The command interface converter 1111 may transmit the SCA protocol command corresponding to the legacy protocol command to the NAND flash memory chips 1120 through CA_CLK, CA[M:0], and CA_CE[N:0] pins of the NAND flash memory chips 1120. Each NAND flash memory chip may be selected according to CA_CE[N:0]. In an example embodiment, the command interface converter 1111 may recognize a command transmitted from the controller 1200 as a legacy command by receiving a ground voltage from a protocol conversion activation pin SCA connected to a ground terminal GND.

The command interface converter 1111 may be implemented to read data from the CA[M:0] pin of the plurality of NAND flash memory chips 1120 according to the SCA protocol from one of a plurality of NAND flash memory chips 1120 and may convert the data to a data format of the legacy protocol. The converted data may be transferred to the controller 1200 using DQS and DQ pins. For example, during a command read operation, the command interface converter 1111 may receive CA_CE[N:0] and nRE_N clock from the selected NAND flash memory chip, and may transmit DQ data and DQS clock of a legacy protocol corresponding thereto to the controller 1200, thereby performing a legacy protocol conversion operation. The CA[M:0] pin may include both clock and data. In an example embodiment, the command interface converter 1111 may recognize data transmitted to one of the plurality of NAND flash memory chips 1120 as data according to the SCA protocol by receiving the power voltage from the protocol conversion activation pin SCA_N connected to the power terminal VDD.

Although not illustrated, the command interface converter 1111 may include a command decoder, a counter, a serial converter, a deserial converter, a multiplexer and a retiming circuit.

The command interface converter 1111 may receive CA[M:0] of NAND flash memory chip as clock and data using an nRE clock of the legacy controller 1200, and may convert the data to a legacy format of DQ data and DQS clock for the controller 1200. The command interface converter 1111 may receive a legacy protocol command of ALE/CLE/nWE/CE[N:0] of the controller 1200 and may convert the legacy protocol command to an SCA protocol command of CA[M:0], CA_CLK, and CA_CE for the plurality of NAND flash memory chips 1120. The command interface converter 1111 may convert the received legacy protocol command into the SCA protocol command in consideration of the CE[N:0] pin.

The buffer chip 1110 may communicate with other NAND flash memory chips 1120 connected to other channels.

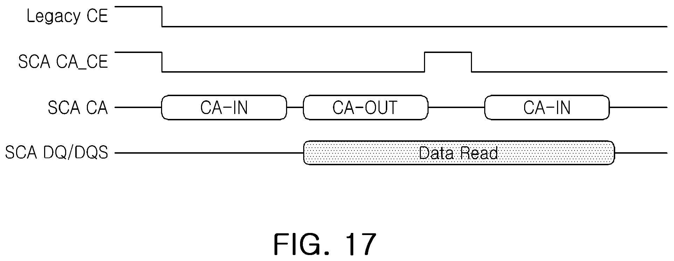

FIG. 17 is a diagram illustrating an example of a bidirectional CA pin operation of a NAND flash memory chip of a storage device 1000 of FIG. 16. Referring to FIG. 17, when a legacy CE pin of the controller-side CTRL-NIF has a low level and the CA_CE pin of the NAND-side NVM-NIF has a low level, CA input data CA-IN and CA output data CA-OUT may be output to the corresponding NAND flash memory chip through the SCA CA pin CA[M:0]. The CA input data CA-IN may include a command and an address, and CA output data CA-OUT may include command data. Data may be output to the SCA DQ/DQS pin DQ_N and DQS_N. In this case, the SCA CA_CE pin CA[M:0] may maintain a high level for a predetermined period of time (e.g., 30ns) and may transition to a low level. While data is output through the SCA DQ/DQS pins DQ_N and DQ_N, the CA input data CA-IN may be received from the NAND flash memory chip through the SCA CA pin CA[M:0].

Referring to FIGS. 16 and 17, a process of conversion from the legacy protocol of the buffer chip 1110 to the SCA protocol may be performed as described below. The controller 1200 (CTRL) may output the legacy protocol command of ALE/CLE/WE/DQ[N:0] and the legacy protocol data of DQ/DQS to the CTRL-NIF of the buffer chip 1110. The NVM-NIF of the buffer chip 1110 may output an SCA protocol command corresponding to the legacy protocol command using CA[1]/CA[0]/CA_CLK pins and the SCA protocol data corresponding to the legacy protocol data using CA[1]/CA[0] pins to the NAND chip NVM. Accordingly, the SCA CA pin CA[M:0] may be used bidirectional communication between the controller 1200 and the plurality of NAND flash memory chips 1120.

The legacy protocol of the controller 1200 may transmit command data and write data to the CTRL-NIF of the buffer chip 1110 in sequence. The NVM-NIF of the buffer chip 1110 may transmit command data and write data according to the converted SCA protocol to the NAND chip NVM.

The SCA protocol of the NAND chip NVM may transmit read data through DQ/DQS and command data through CA[M:0] to the NVM-NIF of the buffer chip 1110 at the same time. In this case, the command interface converter 1111 may store read data and command data in the buffer chip 1110, and may output read data and command data from CTRL-NIF to the controller 1200 based on priority in a sequential manner of legacy protocol. The legacy protocol may receive both read data and command data through DQ/DQS.

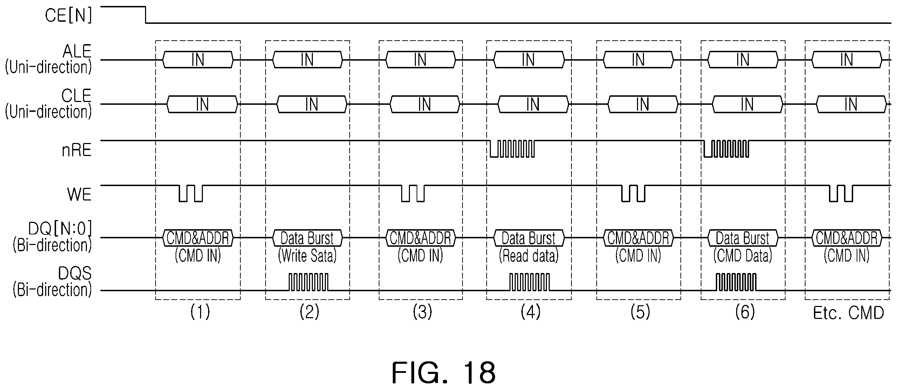

FIG. 18 is a diagram illustrating the timing of a legacy interface between the controller 1200 and the buffer chip 1110 in the storage device 1000 of FIG. 16.
(1) Input command and address: When a CE[N] signal has a "low level," command and address information may be issued using ALE/CLE/WE/DQ[N:0] pins.
(2) Write data: When the CE[N] signal has a "low level," a DQS clock and DQ data may be used for a write operation.
(3) Input command and address: When the CE[N] signal has a "low level," a command and address may be issued using ALE/CLE/WE/DQ[N:0] pins.
(4) Read data: A read operation may be performed using the nRE clock, and when the signal CE[N] has a "low level," read data may be transmitted through the DQ data and the DQS clock.
(5) Input command and address (e.g., command data read/state read/ID read): Command and address information may be issued when the CE[N] signal has "low level."
(6) Read CMD (output command data): When the CE[N] signal has a "low level," a command read operation may be performed using an nRE clock, and command data may be transmitted through the DQ data pin and the DQS clock pin. Thereafter, other commands and addresses may be entered.

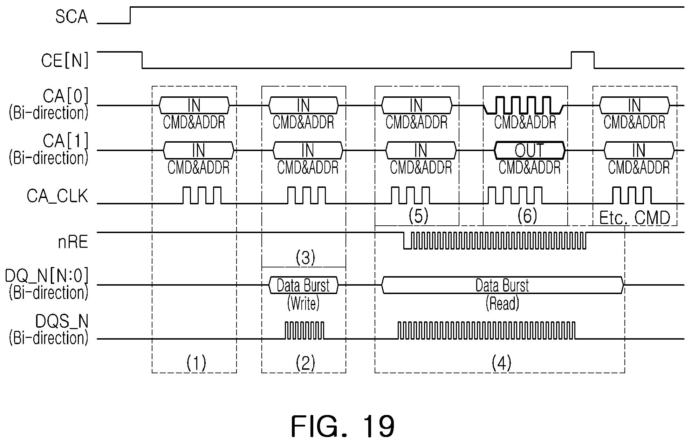

FIG. 19 is a diagram illustrating the timing of an SCA interface between a buffer chip 1110 and a NAND chip NVM in a storage device 1000 of FIG. 16.
(1) Input command and address: Using CA[1]/CA[0]/CA_CLK pins, command and address information may be issued when a CE[N] signal of a CA_CE[N] is a "low level" and an SCA signal of a SCA pin SCA_N is high. A command may be transmitted even during a data burst write/read operation using a DQS_N pin and a DQ_N pin.
(2) Write data: When the CE[N] has a "low level," and the SCA signal of the SCA pin SCA_N has a "high level," DQS clock and DQ data DQS_N and DQ_N pins may be used for a write operation.
(3) Input command and address: When the CE[N] signal has a "low level" and the SCA signal has a "high level," command and address information may be issued using CA[1]/CA[0]/CA_CLK pins. A command may be transmitted even during a data burst write/read operation using the DQS_N and DQ_N pins.
(4) Read data: A read operation may be performed using nRE clock, and when the CE[N] signal has a "low level" and the SCA signal has a "high level," read data may be transmitted through the DQ_N data and DQS_N clock pins.
(5) Input command and address (command data read/state read/ID read): When the CE[N] signal has a "low level" and the SCA signal has a "high level," command and address information may be issued using CA[1]/CA[0]/CA_CLK pins. Commands may be transmitted even during data burst write/read operations using the DQS_N clock pin and the DQ_N data pin.
(6) Read CMD (output command data): When the CE[N] signal has a "low level" and the SCA signal has a "high level," a command read operation may be performed using CA_CLK clock, command data may be transmitted to the DQ data pin of the controller 1200a through the CA[1] pin, and a signal of the pin CA[0] may be transmitted to the DQS clock pin of the controller 1200a as the DQS clock. Accordingly, CA[M:0] may be used for bidirectional purposes as a command data write and read operation.

FIGS. 16 to 19 illustrate communication between the controller 1200 to which a legacy protocol is applied and a NAND flash memory chip 1120 to which an SCA protocol is applied in the storage device 1000. The storage device 1000 in the example embodiment is not limited thereto. For example, a storage device in an example embodiment may be implemented by communication between a controller to which SCA protocol is applied and a NAND flash memory chip to which legacy protocol is applied.

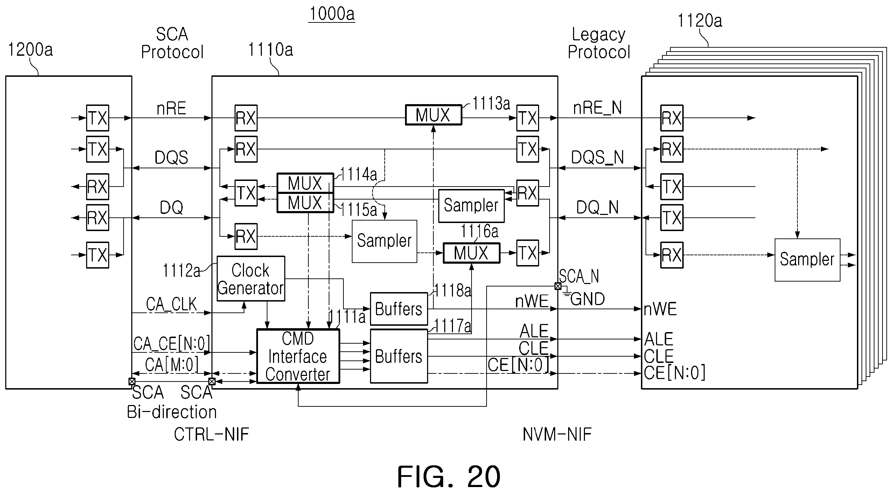

FIG. 20 is a diagram of a storage device according to an example embodiment. Referring to FIG. 20, a storage device 1000a may include a buffer chip 1110a, NAND flash memory chips 1120a communicating according to a legacy protocol, and a controller 1200a communicating according to an SCA protocol. As illustrated in FIG. 20, a pin SCA of the controller 1200a and a pin SCA of the buffer chip 1110a may be connected with each other. A pin SCA_N of the buffer chip 1110a may be connected to a ground terminal GND. The buffer chip 1110a may perform interface protocol conversion through a voltage applied to the pin SCA (i.e., a pin SCA voltage) and a voltage applied to the pin SCA_N (i.e., a pin SCA_N voltage). The buffer chip 1110a may include a command interface converter 1111a, a clock generator 1112a, multiplexers 1113a, 1114a, 1115a, and 1116a, and buffers 1117a and 1118a.

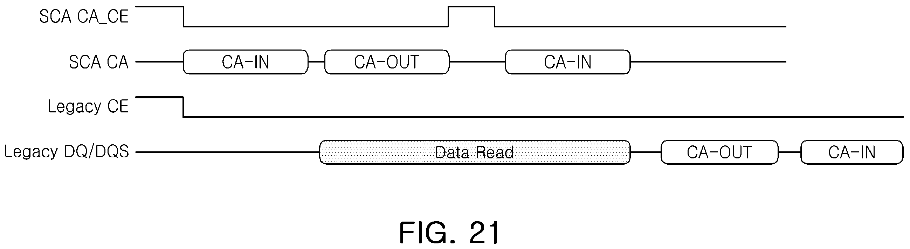

FIG. 21 is a diagram illustrating an example of a bidirectional CA pin operation of a controller of a storage device 1000a of FIG. 20. Referring to FIG. 21, when the SCA CA_CE pin of the controller-side CTRL-NIF has a low level, CA input data CA-IN and CA output data CA-OUT may be received through the SCA CA pin. When CA_CE pin of NAND-side NVM-NIF has a low level, data corresponding to CA input data CA-IN and CA output data CA-OUT may be output to the NAND flash memory chip through a legacy DQ/DQS pin.

Thereafter, the SCA CA_CE pin of the controller-side CTRL-NIF may maintain a high level for a predetermined period of time (e.g., 30 ns) and may transition to a low level. In this case, while data is received through legacy DQ/DQS pins, CA input data CA-IN may be received by the controller 1200a through SCA CA pins simultaneously. In this case, the legacy CE pin may output data CA-OUT and input data CA-IN corresponding to the corresponding command from the NAND flash memory chip through legacy DQ/DQS pins in the low-level state.

Referring to FIGS. 20 and 21, a process of conversion from the SCA protocol of the buffer chip 1110a to the legacy protocol may be performed as described below. The controller 1200a (CTRL) may transmit CA-IN using CA[1]/CA[0]/CA_CLK pins and CA-OUT using CA[1]/CA[0] pins according to SCA protocol to CTRL-NIF of the buffer chip 1110a. Accordingly, the CA[M:0] pins may be bidirectional pins. The NVM-NIF of the buffer chip 1110a may transmit CA-IN of ALE/CLE/WE/DQ[N:0] to the NAND chip NVM according to a legacy protocol and may transmit CA-OUT using the DQ and DQS pins.

The SCA protocol of the controller 1200a (CTRL) may transmit write data through the DQ_N and DQS_N pins and command data through CA[M:0] to the CTRL-NIF of the buffer chip 1110a at the same time. The command interface converter 1111a may store write data and command data in the buffer chip 1110a and may execute the stored commands according to a priority of the legacy protocol. The priority of the legacy protocol may be determined in sequence as when both read data and command data are received through the DQ and DQS pins.

Under the SCA protocol, the controller 1200a (CTRL) may transmit command data and read data to the CTRL-NIF of the buffer chip 1110a. The NVM-NIF of the buffer chip 1110a may transmit the SCA protocol command and data converted from legacy protocol information to the controller 1200a.

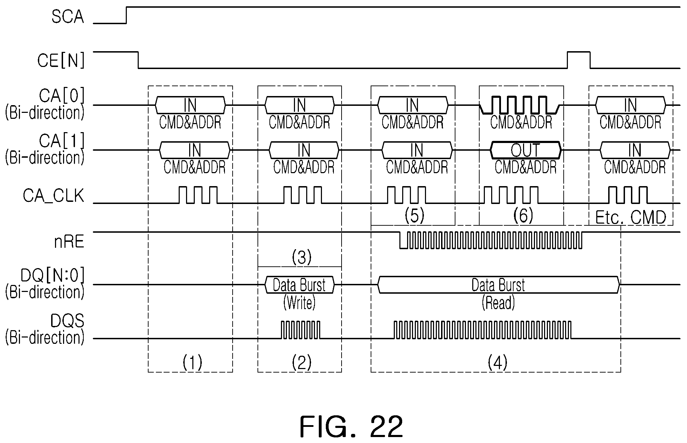

FIG. 22 is a diagram illustrating the timing of an SCA interface between the controller 1200a and the buffer chip 1110a in the storage device 1000a of FIG. 20. Referring to FIG. 22, the timing of the SCA interface between the controller 1200a and the buffer chip 1110a may be the same as the timing of the SCA interface between the buffer chip 1110 and the NAND chip NVM of FIG. 19.

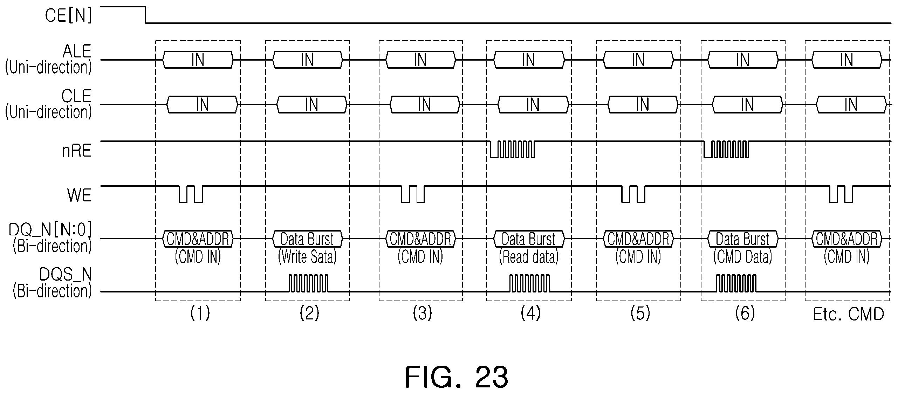

FIG. 23 is a diagram illustrating the timing of a legacy interface between the buffer chip 1110a and the NAND flash memory chips 1120a in the storage device 1000a of FIG. 20. Referring to FIG. 23, the timing of the legacy interface between the buffer chip 1110a and the NAND flash memory chips 1120a may be the same as the timing of the legacy interface between the controller 1200 and the buffer chip 1110 of FIG. 18.

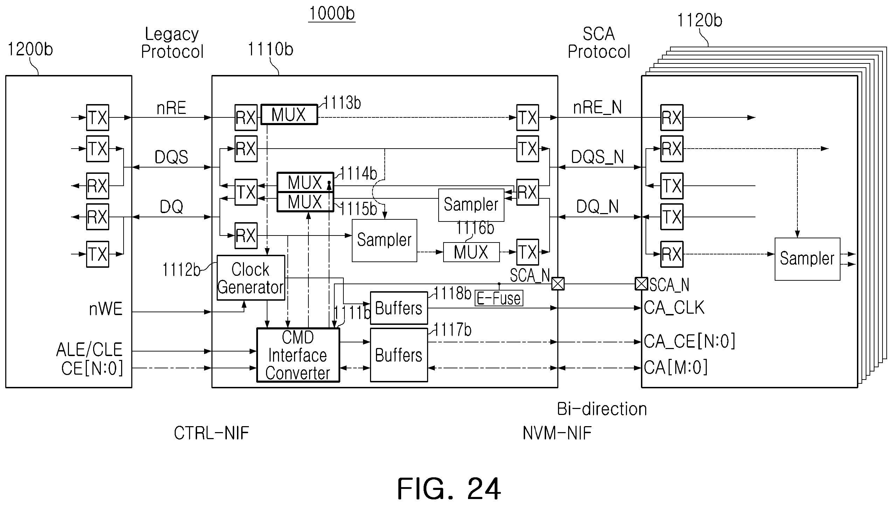

FIG. 24 is a diagram of a storage device 1000b according to an example embodiment. Referring to FIG. 24, as compared to the storage device 1000 of FIG. 16, the storage device 1000b may include a command interface converter 1111b which may connect the protocol conversion activation pin SCA_N of the buffer chip 1110b to each protocol conversion activation pin SCA_N of the NAND flash memory chips 1120b to each other, and may be connected to the protocol conversion activation pin SCA_N of the buffer chip 1110b. The protocol conversion activation pin SCA_N of the buffer chip 1110b may be connected to the E-Fuse so as not to float. However, the E-Fuse technique for preventing the protocol conversion activation pin SCA_N of the buffer chip 1110b of FIG. 24 from floating may be merely an example embodiment. The protocol conversion activation pin SCA_N of the buffer chip 1110b may be connected in various manners so as not to float.

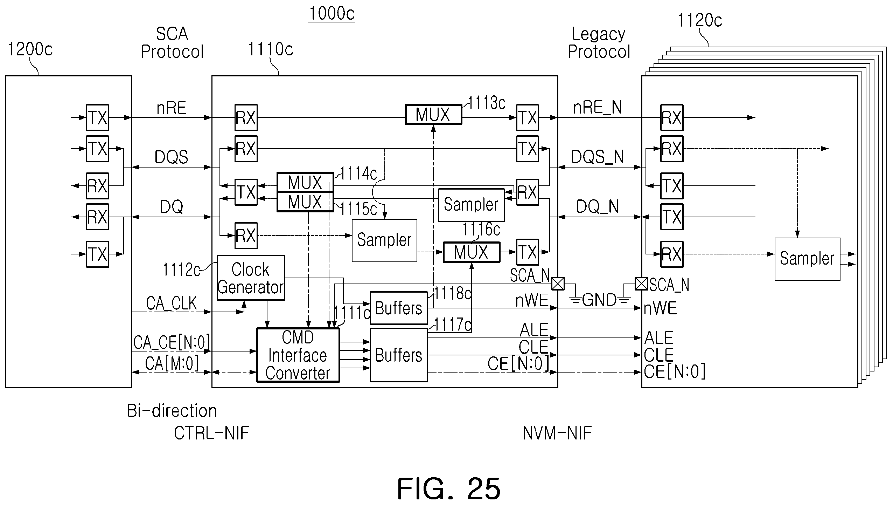

FIG. 25 is a diagram of a storage device 1000c according to an example embodiment. Referring to FIG. 25, the storage device 1000v may include a NAND flash memory chips 1120c having a protocol conversion activation pin SCA_N connected to a ground terminal GND, as compared to the storage device 1000a of FIG. 20.

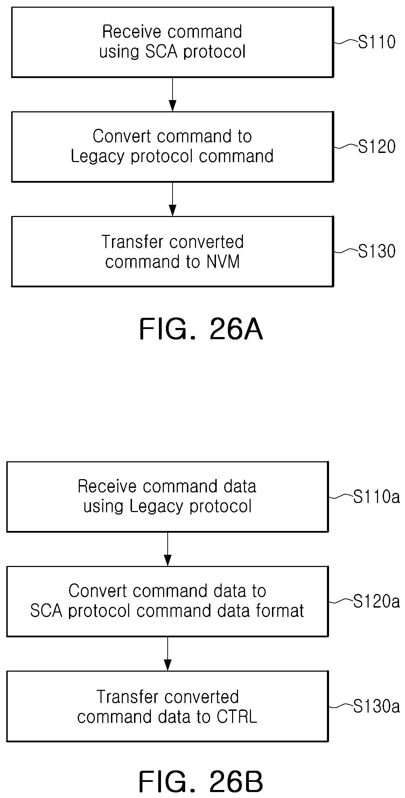

FIGS. 26A and 26D are diagrams illustrating a method of operating an interface chip (FBI) according to an example embodiment. The interface chip FBI may communicate with the controller CTRL according to the SCA protocol, and the nonvolatile memory device NVM may communicate according to the legacy protocol.

Referring to FIG. 26A, the interface chip FBI may support interface protocol conversion when transmitting a command to a nonvolatile memory device NVM. The interface chip FBI may receive a command from the controller CTRL using the SCA protocol (S110). The interface chip FBI may convert the received command into a command according to a legacy protocol (S120). The interface chip FBI may transmit the converted command to the nonvolatile memory device NVM using the legacy protocol (S130).

Referring to FIG. 26B, the interface chip FBI may support interface protocol conversion when transmitting a command to the controller CTRL. The interface chip FBI may receive command data from the nonvolatile memory device NVM using a legacy protocol (S110a). The interface chip FBI may convert the received command into an SCA protocol command data format (S120a). The interface chip FBI may transmit the converted command to the controller CTRL according to the SCA protocol (S130a).

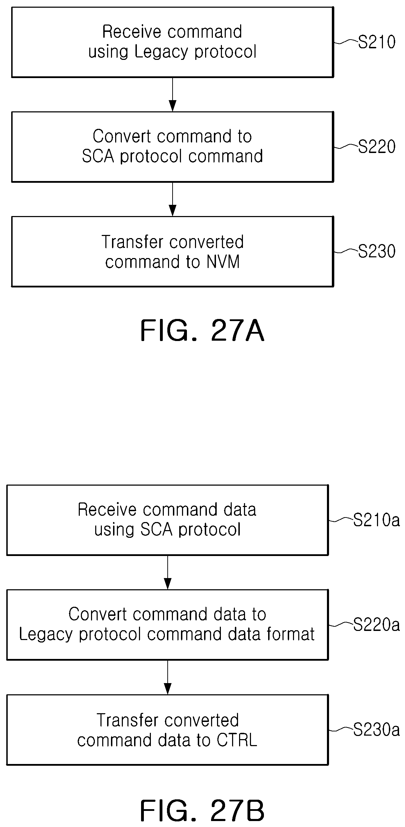

FIGS. 27A and 27B are diagrams illustrating a method of operating an interface chip (FBI) according to an example embodiment. The interface chip FBI may communicate with the controller CTRL according to the legacy protocol, and the nonvolatile memory device NVM may communicate according to the SCA protocol.

Referring to FIG. 27A, the interface chip FBI may support interface protocol conversion as described below when transmitting a command to a nonvolatile memory device NVM. The interface chip FBI may receive a command from the controller CTRL using a legacy protocol (S210). The interface chip FBI may convert the received command into a command according to the SCA protocol (S220). The interface chip FBI may transmit the converted command to the nonvolatile memory device NVM according to the SCA protocol (S230).

Referring to FIG. 27B, the interface chip FBI may support interface protocol conversion as described below when transmitting a command to the controller CTRL. The interface chip FBI may receive command data from the nonvolatile memory device NVM using the SCA protocol (S210a). The interface chip FBI may convert the received command into a legacy protocol command data format (S220a). The interface chip FBI may transmit the converted command to the controller CTRL according to the legacy protocol (S230a).

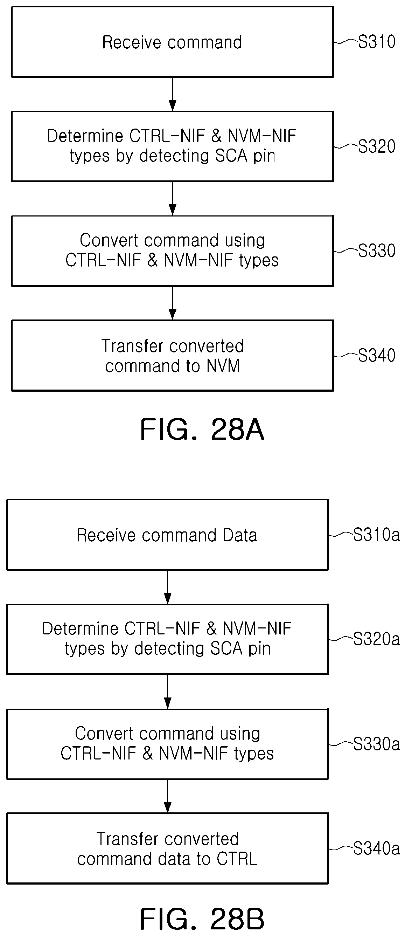

FIGS. 28A and 28B are diagrams illustrating a method of operating an interface chip (FBI) according to an example embodiment. The interface chip FBI may determine the interface protocol types of CTRL-NIF and NVM-NIF by sensing a voltage of the SCA/SAC_N pin.

Referring to FIG. 28A, the interface chip FBI may support interface protocol conversion as described below when transmitting a command to a nonvolatile memory device NVM. The interface chip FBI may receive a command from the controller CTRL (S310). The interface chip FBI may determine the interface protocol types of CTRL-NIF and NVM-NIF by sensing the voltage of the SCA/SCA_N pin (S320). The interface chip FBI may convert the received command into a command according to the interface protocol types of the CTRL-NIF and NVM-NIF (S330). The interface chip FBI may transmit the converted command to the nonvolatile memory device NVM (S340).

Referring to FIG. 28B, the interface chip FBI may support interface protocol conversion as described below when transmitting a command to the controller CTRL. The interface chip FBI may receive command data from the nonvolatile memory device NVM (S310a). The interface chip FBI may determine the interface protocol types of CTRL-NIF and NVM-NIF by sensing a voltage of the SCA/SCA_N pin (S320a). The interface chip FBI may convert the received command into a command according to the interface protocol types of CTRL-NIF and NVM-NIF (S330a). The interface chip FBI may transmit the converted command to the controller CTRL (S340a).

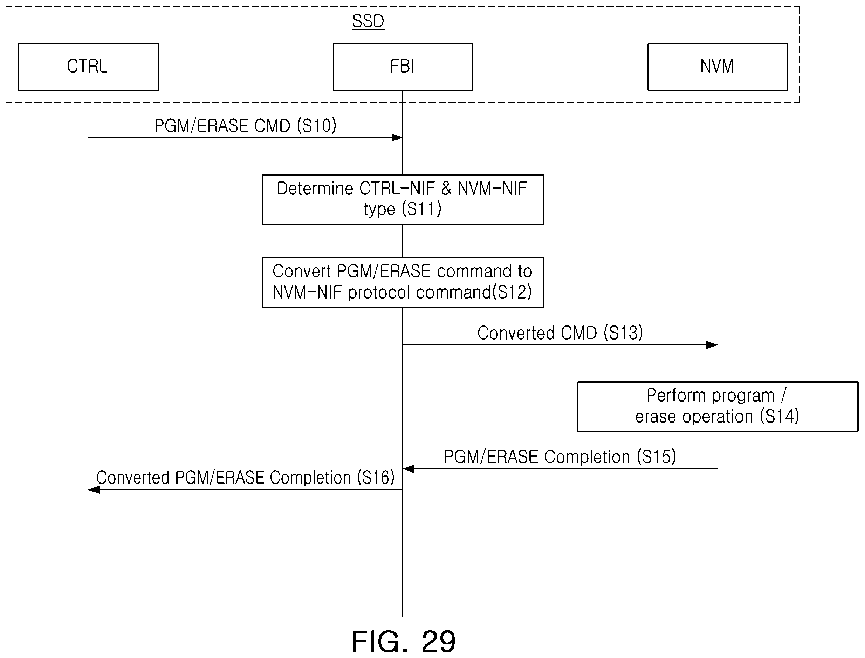

FIG. 29 is a ladder diagram illustrating a program/erase operation of a storage device according to an example embodiment. Referring to FIG. 29, a program/erase operation of a storage device (SSD) may be performed as described below. The controller CTRL may issue a program/erase command and may output the issued program/erase command to the interface chip FBI (S10). The interface chip FBI may determine the interface protocol types of CTRL-NIF and NVM-NIF (S11). The interface chip FBI may convert the received command of to the interface protocol type of CTRL-NIF to a command of the interface protocol type of the NVM-NIF (i.e., NVM-NIF protocol command) (S12). The interface chip FBI may output the NVM-NIF protocol command to a corresponding nonvolatile memory device NVM (S13). The nonvolatile memory device NVM may perform a program/erase operation according to the received command (S14). The nonvolatile memory device NVM may output program/erase completion information to the interface chip FBI (S15). The interface chip FBI may convert the program/erase completion information to CTRL-NIF protocol information corresponding to the program/erase completion information and may output the CTL-NIF protocol information to the controller CTRL (S16).

In an example embodiment, a voltage of a protocol conversion activation pin (SCA/SCA_N pin) may be determined, and one of an SCA protocol and a legacy protocol may be selected according to the determined voltage. In an example embodiment, a program/erase command converted through the CA_CE[N:0] pin may be output to the nonvolatile memory device NVM. In an example embodiment, data may be received from the nonvolatile memory device NVM through a data pin, and a corresponding command may be received through a CA_CE[N:0] pin while receiving the data. In an example embodiment, data may be received from the nonvolatile memory device NVM through a data pin, a command corresponding to the received data may be decoded, and the decoded command may be output to the controller CTRL through the CA_CE[N:0] pin.

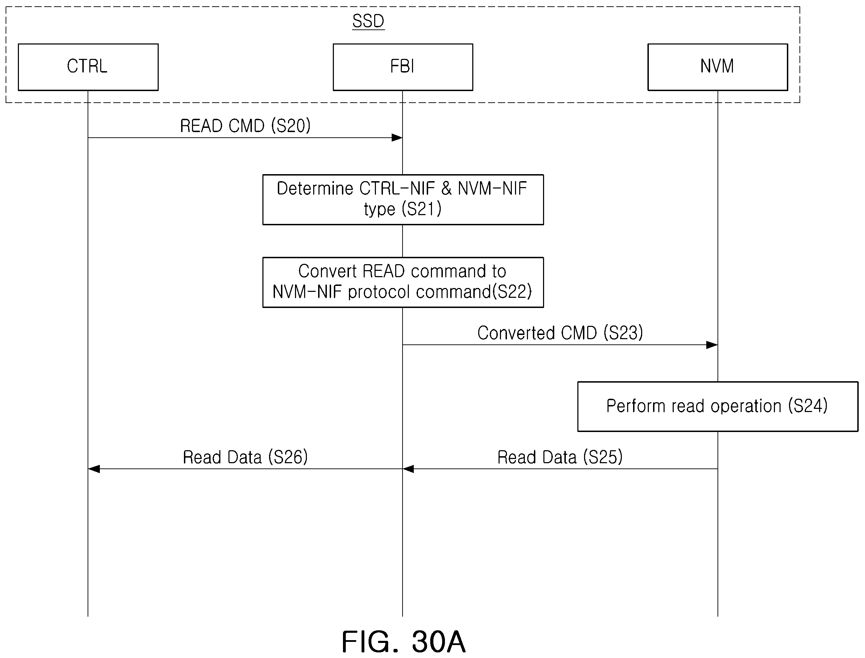

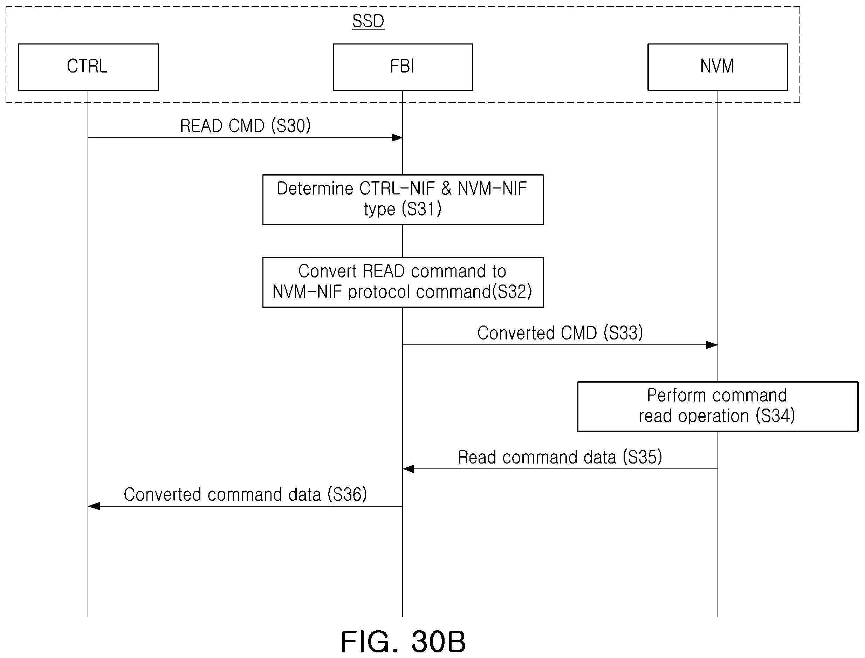

FIGS. 30A and 30B are ladder diagrams illustrating a read operation of a storage device according to an example embodiment.

Referring to FIG. 30A, a read operation of a storage device (SSD) may be performed as described below. The controller CTRL may issue a read command and may output the issued read command to the interface chip FBI (S20). The interface chip FBI may determine the interface protocol type of CTRL-NIF and NVM-NIF (S21). The interface chip FBI may convert the received command of the interface protocol type of CTRL-NIF to a command of the interface protocol type of the NVM-NIF (i.e., an NVM-NIF protocol command) (S22). The interface chip FBI may output the NVM-NIF protocol command to a corresponding nonvolatile memory device NVM (S23). The nonvolatile memory device NVM may perform a read operation according to the received command of the NVM-NIF protocol command (S24). The nonvolatile memory device NVM may output read data according to the read operation to the interface chip FBI (S25). The interface chip FBI may output read data to the controller CTRL (S26).

Referring to FIG. 30B, a command read operation of a storage device (SSD) may be performed as described below. The controller CTRL may issue a read command and may output the issued read command to the interface chip FBI (S30). The interface chip FBI may determine the interface protocol types of CTRL-NIF and NVM-NIF (S31). The interface chip FBI may convert the received command of the interface protocol type of the CTRL-NIF to a command of the interface protocol type of the NVM-NIF (i.e., an NVM-NIF protocol command) (S32). The interface chip FBI may output the NVM-NIF protocol command to a corresponding nonvolatile memory device NVM (S33). The nonvolatile memory device NVM may perform a command read operation according to the received command of the NVM-NIF protocol command (S34). The nonvolatile memory device NVM may output read command data according to the read operation to the interface chip FBI (S35). The interface chip FBI may convert the command data to data of the interface protocol type of the CTRL-NIF and may output the data to the controller CTRL (S36).

The nonvolatile memory device NVM according to the example embodiment may be implemented as a vertical memory device in which a plurality of NVM devices are stacked in a vertical direction.

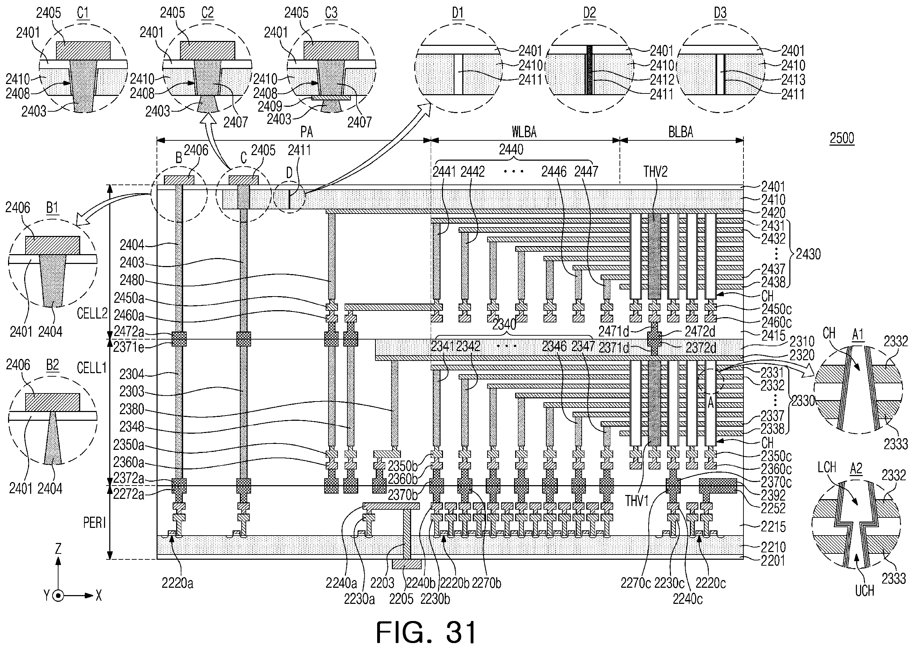

FIG. 31 is a diagram of a nonvolatile memory device according to an example embodiment. Referring to FIG. 31, a nonvolatile memory device 2500 may have a chip to chip (C2C) structure. The C2C structure may be obtained by forming at least one upper chip including a cell region CELL and a lower chip including a peripheral circuit region PERI and connecting the at least one upper chip and the lower chip to each other by a bonding method. In an example embodiment, the bonding method may refer to a method of electrically or physically connecting a bonding metal pattern formed on an uppermost metal layer of an upper chip to a bonding metal pattern formed on an uppermost metal layer of a lower chip. For example, when the bonding metal patterns are formed of copper (Cu), the bonding method may be a Cu-Cu bonding method. In an example embodiment, bonding metal patterns may be formed using aluminum (Al) or tungsten (W).

The nonvolatile memory device 2500 may include at least one upper chip including a cell region. For example, as illustrated in FIG. 31, the nonvolatile memory device 2500 may be implemented to include two upper chips. However, this is merely an example, and the number of upper chips is not limited thereto. When the nonvolatile memory device 2500 is implemented to include two upper chips, a first upper chip including the first cell region CELL1, a second upper chip including the second cell region CELL2, and a lower chip including the peripheral circuit region PERI may be manufactured, and the first upper chip, the second upper chip and the lower chip may be connected with each other by bonding, such that the nonvolatile memory device 2500 may be manufactured. The first upper chip may be inverted and connected to the lower chip by a bonding method, and the second upper chip may be inverted and connected to the first upper chip by a bonding method. In the description below, the upper portion and the lower portion of the first and second upper chips may be defined with respect to the state before the first upper chip and the second upper chip are inverted. In FIG. 31, the upper portion of the lower chip may refer to the upper portion defined with respect to the +Z-axis direction, and the upper portion of each of the first and second upper chips may refer to the upper portion defined with respect to the -Z-axis direction. However, this is merely an example, and only one of the first upper chip and the second upper chip may be inverted and connected by a bonding method.

Each of the peripheral circuit region PERI and the first and second cell regions CELL1 and CELL2 of the nonvolatile memory device 2500 may include an external pad bonding region PA, a wordline bonding region WLBA, and a bitline bonding region BLBA.

The peripheral circuit region PERI may include a first substrate 2210 and a plurality of circuit devices 2220a, 2220b, and 2220c formed on the first substrate 2210. An interlayer insulating layer 2215 including one or more insulating layers may be provided on the plurality of circuit devices 2220a, 2220b, and 2220c, and a plurality of metals wirings connecting the plurality of circuit devices 2220a, 2220b, and 2220c to each other may be provided in the interlayer insulating layer 2215. For example, the plurality of metal wirings may include first metal wiring 2230a, 2230b, and 2230c connected to a plurality of circuit devices 2220a, 2220b, and 2220c, and second metal wiring 2240a, 2240b formed on first metal wiring 2230a, 2230b, and 2230c, 2240c. The plurality of metal wirings may be formed of at least one of various conductive materials. For example, the first metal wirings 2230a, 2230b, and 2230c may be formed of tungsten having a relatively high electrical resistivity, and the second metal wirings 2240a, 2240b, and 2240c may be formed of copper having a relatively low electrical resistivity.

Here, only the first metal wiring 2230a, 2230b, 2230c and the second metal wiring 2240a, 2240b, 2240c are described, but an example embodiment thereof is not limited thereto, and at least one or more additional metal wiring may be formed on the second metal wiring 2240a, 2240b, and 2240c. In this case, the second metal wirings 2240a, 2240b, and 2240c may be formed of aluminum. At least a portion of the additional metal wiring formed on the second metal wirings 2240a, 2240b, and 2240c may be formed of copper having lower electrical resistivity than that of aluminum of the second metal wirings 2240a, 2240b, and 2240c.

The interlayer insulating layer 2215 may be disposed on the first substrate 2210 and may include an insulating material such as silicon oxide and silicon nitride.

Each of the first and second cell regions CELL1 and CELL2 may include at least one memory block. The first cell region CELL1 may include a second substrate 2310 and a common source line 2320. A plurality of wordlines 2331 to 2338 (2330) may be stacked on the second substrate 2310 in a direction (Z-axis direction) perpendicular to the upper surface of the second substrate 2310. String selection lines and ground selection lines may be disposed above and below the wordlines 2330, and a plurality of wordlines 2330 may be disposed between the string selection lines and the ground selection line. Similarly, the second cell region CELL2 may include a third substrate 2410 and a common source line 2420, and a plurality of wordlines 2431-2438 (2430) may be stacked in a direction (Z-axis direction) perpendicular to the upper surface of the third substrate 2410. The second substrate 2310 and the third substrate 2410 may be formed of a variety of materials, and may be implemented as, for example, a silicon substrate, a silicon-germanium substrate, a germanium substrate, or a substrate with a monocrystalline epitaxial layer grown on a monocrystalline silicon substrate. A plurality of channel structure CHs may be formed in each of the first and second cell regions CELL1 and CELL2.

In an example embodiment, as illustrated in A1, the channel structure CH may be provided in the bitline bonding region BLBA and may extend in a direction perpendicular to the upper surface of the second substrate 2310 and may penetrate through the wordlines 2330, string selection lines, and a ground selection line. The channel structure CH may include a data storage layer, a channel layer, and a buried insulating layer. The channel layer may be electrically connected to the first metal wiring 2350c and the second metal wiring 2360c in the bitline bonding region BLBA. For example, the second metal wiring 2360c may be configured as a bitline and may be connected to the channel structure CH through the first metal wiring 2350c. The bitline 2360c may extend in the first direction (Y-axis direction) parallel to the upper surface of the second substrate 2310.

As illustrated in an example embodiment, A2, the channel structure CH may include a lower channel LCH and an upper channel UCH connected with each other. For example, the channel structure CH may be formed through a process for a lower channel LCH and a process for an upper channel UCH. The lower channel LCH may extend in a direction perpendicular to the upper surface of the second substrate 2310 and may penetrate through the common source line 2320 and the lower wordlines 2331 and 2332. The lower channel LCH may include a data storage layer, a channel layer and a buried insulating layer, and may be connected to the upper channel UCH. The upper channel UCH may penetrate through the upper wordlines 2333 to 2338. The upper channel UCH may include a data storage layer, a channel layer and a buried insulating layer, and the channel layer of the upper channel UCH may be electrically connected to the first metal wiring 2350c and the second metal wiring 2360c. As the length of the channel increases, it may be difficult to form a channel having a constant width due to process reasons. The nonvolatile memory device 2500 according to the example embodiment may include a channel having improved width uniformity through a lower channel LCH and an upper channel UCH formed through processes performed in sequence.

As illustrated in A2, when the channel structure CH is formed to include a lower channel LCH and an upper channel UCH, a wordline disposed in approximate to a boundary of the lower channel LCH and the upper channel UCH may be configured as a dummy wordline. For example, the wordline 2332 and the wordline 2333 forming a boundary between the lower channel LCH and the upper channel UCH may be dummy wordlines. In this case, data may not be stored in the memory cells connected to the dummy wordline. Alternatively, the number of pages corresponding to memory cells connected to a dummy wordline may be less than the number of pages corresponding to memory cells connected to a general wordline. The voltage level applied to the dummy wordline may be different from the voltage level applied to the general wordline, and accordingly, the effect of the non-uniform channel width between the lower channel LCH and the upper channel UCH on the operation of the memory device may be reduced.

In A2, the number of the lower wordlines 2331 and 2332 penetrating through the lower channel LCH may be smaller than the number of the upper wordlines 2333 to 2338 penetrating through the upper channel UCH. However, this is merely an example, and an example embodiment thereof is not limited thereto. In an example embodiment, the number of lower wordlines penetrating through the lower channel LCH may be equal to or greater than the number of upper wordlines penetrating through the upper channel UCH. The structure and the connection relationship of the channel structure CH disposed in the first cell region CELL1 described above may be applied to the channel structure CH disposed in the second cell region CELL2.

In a bitline bonding region BLBA, a first through-electrode THV1 may be provided to a first cell region CELL1, and a second through-electrode THV2 may be provided to a second cell region CELL2. As illustrated in FIG. 31, a first through-electrode THV1 may penetrate through a common source line 2320 and a plurality of wordlines 2330. However, this is merely an example, and the first through-electrode THV1 may further penetrate the second substrate 2310. The first through-electrode THV1 may include a conductive material. Alternatively, the first through-electrode THV1 may include a conductive material surrounded by an insulating material. The second through-electrode THV2 may be provided in the same form and structure as those of the first through-electrode THV1.

In an example embodiment, the first through-electrode THV1 and the second through-electrode THV2 may be electrically connected through a first through-metal pattern 2372d and a second through-metal pattern 2472d. The first through-metal pattern 2372d may be formed on a lower end of the first upper chip including the first cell region CELL1, and the second through-metal pattern 2472d may be formed on an upper end of the second upper chip including the second cell region CELL2. The first through-electrode THV1 may be electrically connected to the first metal wiring 2350c and the second metal wiring 2360c. A lower via 2371d may be formed between the first through-electrode THV1 and the first through-metal pattern 2372d, and an upper via 2471d may be formed between the second through-electrode THV2 and the second through-metal pattern 2472d. The first through-metal pattern 2372d and the second through-metal pattern 2472d may be connected with each other by a bonding method.

In the bitline bonding region BLBA, the upper metal pattern 2252 may be formed on an uppermost metal layer of the peripheral circuit region PERI, and an upper metal pattern 2392 having the same shape as that of the upper metal pattern 2252 may be formed on the uppermost metal layer of the first cell region CELL1. The upper metal pattern 2392 of the first cell region CELL1 and the upper metal pattern 2252 of the peripheral circuit region PERI may be electrically connected with each other by a bonding method. In the bitline bonding region BLBA, the bitline 2360c may be electrically connected to the page buffer included in the peripheral circuit region PERI. For example, a portion of the circuit devices 2220c of the peripheral circuit region PERI may provide a page buffer, and the bitline 2360c may be electrically connected to the circuit devices 2220c providing a page buffer through the upper bonding metal 2370c of the first cell region CELL1 and the upper bonding metal 2270c of the peripheral circuit region PERI.

Referring to FIG. 31, in the wordline bonding region WLBA, the wordlines 2330 of the first cell region CELL1 may extend in a second direction (X-axis direction) parallel to the upper surface of the second substrate 2310, and may be connected to a plurality of cell contact plugs 2341-2347 (340). A first metal wiring 2350b and a second metal wiring 2360b may be connected to an upper portion of the cell contact plugs 2340 connected to the wordlines 2330. The cell contact plugs 2340 may be connected to the peripheral circuit region PERI through the upper bonding metal 2370b of the first cell region CELL1 and the upper bonding metal 2270b of the peripheral circuit region PERI in the wordline bonding region WLBA.

The cell contact plugs 2340 may be electrically connected to a row decoder included in the peripheral circuit region PERI. For example, a portion of the circuit devices 2220b of the peripheral circuit region PERI may provide a row decoder, and the cell contact plugs 2340 may be electrically connected to the circuit devices 2220b providing a row decoder through the upper bonding metal 2370b of the first cell region CELL1 and the upper bonding metal 2270b of the peripheral circuit region PERI. In an example embodiment, the operation voltage of circuit devices 2220b providing a row decoder may be different from the operation voltage of circuit devices 2220c providing a page buffer. For example, an operation voltage of circuit devices 2220c providing a page buffer may be greater than an operation voltage of circuit devices 2220b providing a row decoder.

In the wordline bonding region WLBA, the wordlines 2430 of the second cell region CELL2 may extend in the second direction (X-axis direction) parallel to the upper surface of the third substrate 2410, and may be connected to a plurality of cell contact plugs 2441-2447 (2440). The cell contact plugs 2440 may be connected to the peripheral circuit region PERI through the upper metal pattern of the second cell region CELL2, the lower metal pattern and upper metal pattern of the first cell region CFLL1, and the cell contact plug 2348.

In the wordline bonding region WLBA, an upper bonding metal 2370b may be formed in the first cell region CELL1, and an upper bonding metal 2270b may be formed in the peripheral circuit region PERI. The upper bonding metal 2370b of the first cell region CELL1 and the upper bonding metal 2270b of the peripheral circuit region PERI may be electrically connected with each other by a bonding method. The upper bonding metal 2370b and the upper bonding metal 2270b may be formed of aluminum, copper or tungsten.

In the external pad bonding region PA, a lower metal pattern 2371e may be formed below the first cell region CELL1, and an upper metal pattern 2472a may be formed above the second cell region CELL2. The lower metal pattern 2371e of the first cell region CELL1 and the upper metal pattern 2472a of the second cell region CELL2 may be connected with each other by a bonding method in the external pad bonding region PA. Similarly, an upper metal pattern 2372a may be formed on the first cell region CELL1, and an upper metal pattern 2272a may be formed on the peripheral circuit region PERI. The upper metal pattern 2372a of the first cell region CELL1 and the upper metal pattern 2272a of the peripheral circuit region PERI may be connected with each other by a bonding method.

Common source line contact plugs 2380 and 2480 may be disposed in the external pad bonding region PA. The common source line contact plugs 2380 and 2480 may be formed of a conductive material such as metal, metal compound, and doped polysilicon. The common source line contact plug 2380 of the first cell region CELL1 may be electrically connected to the common source line 2320, and the common source line contact plug 2480 of the second cell region CELL2 may be electrically connected to the common source line 2420. The first metal wiring 2350a and the second metal wiring 2360a may be stacked in order on the common source line contact plug 2380 of the first cell region CELL1, and the first metal wiring 2450a and the second metal wiring 2460a may be stacked in order on the common source line contact plug 2480 of the second cell region CELL2.

The input/output pads 2205, 2405, and 2406 may be disposed in the external pad bonding region PA. Referring to FIG. 31, a lower insulating film 2201 may cover the lower surface of the first substrate 2210, and a first input/output pad 2205 may be formed on the lower insulating film 2201. The first input/output pad 2205 may be connected to at least one of the plurality of circuit devices 2220a disposed in the peripheral circuit region PERI through the first input/output contact plug 2203, and may be isolated from the first substrate 2210 by the lower insulating film 2201. A side insulating film may be disposed between the first input/output contact plug 2203 and the first substrate 2210 and may electrically isolate the first input/output contact plug 2203 and the first substrate 2210 from each other.

An upper insulating film 2401 covering an upper surface of the third substrate 2410 may be formed on the third substrate 2410. A second input/output pad 2405 or a third input/output pad 2406 may be disposed on the upper insulating film 2401. The second input/output pad 2405 may be connected to at least one of the plurality of circuit devices 2220a disposed in the peripheral circuit region PERI through the second input/output contact plugs 2403 and 2303, and the third input/output pad 2406 may be connected to at least one of a plurality of circuit devices 2220a disposed in the peripheral circuit region PERI through the third input/output contact plugs 2404 and 2304.

In an example embodiment, the third substrate 2410 may not be disposed in a region in which an input/output contact plug is disposed. For example, as illustrated in B, the third input/output contact plug 2404 may be isolated from the third substrate 2410 in a direction parallel to the upper surface of the third substrate 2410, and may penetrate through the interlayer insulating layer 2415 of the second cell region CELL2 and may be connected to the input/output pad 2406. In this case, the third input/output contact plug 2404 may be formed through various processes.

For example, as illustrated in B1, the third input/output contact plug 2404 may extend in a third direction (Z-axis direction) and may have a diameter increasing toward the upper insulating film 2401. While the diameter of the channel structure CH described in A1 is formed to decrease toward the upper insulating film 2401, the diameter of the third input/output contact plug 2404 may be formed to increase toward the upper insulating film 2401. For example, the third input/output contact plug 2404 may be formed after the second cell region CELL2 and the first cell region CELL1 are bonded to each other using a bonding method.

In an example embodiment, as illustrated in B2, the third input/output contact plug 2404 may extend in a third direction (Z-axis direction) and may have a diameter decreasing toward the upper insulating film 2401. The diameter of the third input/output contact plug 2404 may decrease toward the upper insulating film 2401 similarly to the channel structure CH. For example, the third input/output contact plug 2404 may be formed together with the cell contact plugs 2440 before bonding between the second cell region CELL2 and the first cell region CELL1.

In an example embodiment, the input/output contact plug may be disposed to overlap the third substrate 2410. For example, as illustrated in C, the second input/output contact plug 2403 may penetrate through the interlayer insulating layer 2415 of the second cell region CELL2 in the third direction (Z-axis direction), and may be electrically connected to the second input/output pad 2405 through the third substrate 2410. In this case, the connection structure of the second input/output contact plug 2403 and the second input/output pad 2405 may be implemented in various manners.

For example, as illustrated in C1, an opening 2408 penetrating through the third substrate 2410 may be formed, and a second input/output contact plug 2403 may be directly connected to the second input/output pad 2405 through the opening 2408 formed in the third substrate 2410. In this case, as illustrated in C1, the diameter of the second input/output contact plug 2403 may increase toward the second input/output pad 2405. However, this is merely an example, and the diameter of the second input/output contact plug 2403 may be formed to decrease toward the second input/output pad 2405.

For example, as illustrated in C2, an opening 2408 penetrating through the third substrate 2410 may be formed, and a contact 2407 may be formed within the opening 2408. One end of the contact 2407 may be connected to the second input/output pad 2405, and the other end may be connected to the second input/output contact plug 2403. Accordingly, the second input/output contact plug 2403 may be electrically connected to the second input/output pad 2405 through the contact 2407 in the opening 2408. In this case, as illustrated in C2, the diameter of the contact 2407 may increase toward the second input/output pad 2405, and the diameter of the second input/output contact plug 2403 may decrease toward the second input/output pad 2405. For example, the third input/output contact plug 2403 may be formed together with the cell contact plugs 2440 before bonding between the second cell region CELL2 and the first cell region CELL1, and the contact 2407 may be formed after bonding between the second cell region CELL2 and the first cell region CELL.

In an embodiment, as illustrated in C3, a stopper 2409 may be further formed on the upper surface of the opening 2408 of the third substrate 2410 as compared to C2. The stopper 2409 may be a metal wiring formed on the same layer as the common source line 2420. However, this is merely an example, and the stopper 2409 may be a metal wiring formed on the same layer as at least one of the wordlines 2430. The second input/output contact plug 2403 may be electrically connected to the second input/output pad 2405 through the contact 2407 and the stopper 2409.

Similarly to the second and third input/output contact plugs 2403 and 2404 of the second cell region CELL2, the second and third input/output contact plugs 2303 and 2304 of the first cell region CELL1 may be formed to have a diameter decreasing toward the lower metal pattern 2371e or to have a diameter increasing toward the lower metal pattern 2371e.

In example embodiments, a slit 2411 may be formed on the third substrate 2410. For example, the slit 2411 may be formed in an arbitrary position of the external pad bonding region PA. In an example embodiment, as illustrated in D, the slit 2411 may be disposed between the second input/output pad 2405 and the cell contact plugs 2440 when viewed in a plan diagram. However, this is merely an example, and the slit 2411 may be formed such that the second input/output pad 2405 may be disposed between the slit 2411 and the cell contact plugs 2440 when viewed in a plan diagram.

For example, as illustrated in D1, the slit 2411 may be formed to penetrate through the third substrate 2410. The slit 2411 may be used to prevent the third substrate 2410 from being finely split when the opening 2408 is formed, for example. However, this is merely an example, and the slit 2411 may be formed to a depth of about 60% to 70% of the thickness of the third substrate 2410.

In an example embodiment, as illustrated in D2, a conductive material 2412 may be formed in the slit 2411. The conductive material 2412 may be used, for example, to discharge leakage current generated during driving of circuit devices in the external pad bonding region PA to the outside. In this case, the conductive material 2412 may be connected to an external ground line.

In an example embodiment, as illustrated in D3, an insulating material 2413 may be formed in the slit 2411. The insulating material 2413 may be formed, for example, to electrically isolate the second input/output pad 2405 and the second input/output contact plug 2403 disposed in the external pad bonding region PA from the wordline bonding region WLBA. By forming the insulating material 2413 in the slit 2411, the voltage provided through the second input/output pad 2405 may be prevented from affecting the metal layer disposed on the third substrate 2410 in the wordline bonding region WLBA.

In example embodiments, the first to third input/output pads 2205, 405, and 406 may be selectively formed. For example, the nonvolatile memory device 2500 may include only a first input/output pad 2205 disposed on the first substrate 2201. In an embodiment, the nonvolatile memory device 2500 may include only a second input/output pad 2405 disposed on the third substrate 2410. In an embodiment, the nonvolatile memory device 2500 may include only the third input/output pad 2406 disposed on the upper insulating film 2401.

In example embodiments, at least one of the second substrate 2310 of the first cell region CELL1 and the third substrate 2410 of the second cell region CELL2 may be used as a sacrificial substrate, and may be completely or partially removed before or after a bonding process. An additional film may be deposited after removing a substrate. For example, the second substrate 2310 of the first cell region CELL1 may be removed before or after bonding between the peripheral circuit region PERI and the first cell region CELL1, and an insulating film covering the upper surface of the common source line 2320 or a conductive film for connection may be formed. Similarly, the third substrate 2410 of the second cell region CELL2 may be removed before or after the bonding between the first cell region CELL1 and the second cell region CELL2, and the upper insulating film 2401 covering the upper surface of the common source line 2420 or a conductive film for connection may be formed.

The device as described above may be implemented as a hardware component, a software component, and/or a combination of a hardware component and a software component. For example, the devices and components described in the example embodiment may be implemented using one or more general-purpose or special-purpose computers, such as a processor, a controller, an arithmetic logic unit (ALU), a digital signal processor, a microcomputer, a field programmable gate array (FPGA), and a programmable logic unit (PLU), a microprocessor, or any other device capable of executing and responding to instructions. The processing device may execute an operating system (OS) and one or more software applications executed on the operating system. The processing device may access, store, manipulate, process, and create data in response to software execution. For ease of understanding, in the example embodiment, one processing device may be used, but the processing device may include a plurality of processing elements or a plurality of types of processing elements. For example, a processing device may include a plurality of processors or one processor and one controller. Other processing configurations, such as a parallel processor, may be provided.

Software may include a computer program, code, instruction, or a combination of one or more thereof, and may configure a processing device to operate as desired, or may independently or collectively instruct a processing device. Software and/or data may be embodied in any type of machine, component, physical device, virtual device, computer storage medium or device to be interpreted by or to provide instructions or data to a processing device. Software may be distributed on a networked computer system and may be stored or executed in a distributed manner. Software and data may be stored in one or more computer readable media.

In the example embodiment, an interface between a new protocol SCA and a legacy protocol may be provided. An interface chip according to an example embodiment may include an internal clock generator, a first command interface converter circuit, a second command interface converter circuit, and a plurality of multiplexers between a controller and a NAND memory device. The command interface logic circuit may include a serializer, a demultiplexer, a retiming unit, a decoder and a multiplexer.

In an example embodiment, the first command interface converter circuit may receive CA_CE, CA[M:0], and CA_CLK clocks from a new protocol and may convert the clocks to legacy protocol format (ALE/CLE/DQ/CE/nRE clock/nWE clock) using internal clock generator, and may receive DQS clock and DQ Data, and may convert the clock and data to new protocol format of CA[M:0], which may indicate that bidirectional CA operation may be performed while considering CA_CE.

In an example embodiment, the second command interface converter circuit may receive ALE, CLE, CE[N:0], nRE clock, and nWE clock from legacy protocol and may convert the clocks to new protocol format(CA_CE/CA[M:0]/CA_CLK) using an internal clock, and may receive a clock of an oscillator and CA[M:0], and may convert the clock to legacy protocol format (DQ Data and DQS).

As described above, in the example embodiment, a buffer chip or an interface chip supported by multi-protocol communication to support legacy and new protocols of a controller and memory chip using a bidirectional CA interface converter. Differently from the prior art, in the example embodiment, to communicate with different protocol controllers and memory chips, CMD interface conversion may be attempted using bidirectional CA pins. In the example embodiment, a command may be converted from protocol 1 to protocol 2 and from protocol 2 to protocol 1 considering chip enable CA_CE/CE. In the example embodiment, a bidirectional command conversion may be performed. In the example embodiment, differently from general DQ and DQS clocks, a read command may be performed using CA[M:0] of new protocol using CA_LCK. Differently from the general DQ and DQS clocks, in the example embodiment, by converting CA[M:0] of the new protocol, the read command may be performed with the DQ and DQS clock of the new protocol using the nRE clock.

In the example embodiment, a buffer chip new protocol SCA and legacy protocol (up to toggle 5.0) with Toggle 6.0 function may be supported. The buffer chip may include an interface converter configured to decode the legacy protocol CMD (DQ/ALE/CLE/CE) and to communicate with the new protocol memory chip through CA_CE and CA pins. Similarly, the buffer chip may read the CA data of the new protocol and may convert the data to legacy protocols DQS and DQ. Similarly, communication between the new protocol and legacy memory chips may be supported by an interface converter for CA_CE/CA_CE of the new protocol and ALE/CLE/DQ/CE of the legacy protocol. A buffer chip supporting multi-protocol communication may be implemented to support legacy and new protocols of a controller and memory chip. In the example embodiment, a buffer chip working as an interface between the legacy and SCA (New) protocols of a controller and a memory chip may be disclosed, and the buffer chip may be configured as an interface converter which may transmit and receive different protocol data and clocks by decoding each protocol data format, and CA and CA_CLK may perform bidirectional communication.

According to the aforementioned example embodiments, the nonvolatile memory package, the storage device including the same, and the method of operating the same may, by including an interface chip configured to convert the first interface protocol to the second interface protocol or to convert the second interface protocol to the first interface protocol, support multi-protocol.

The nonvolatile memory package, the storage device including the same, and the method of operating the same may, by including an interface chip (or buffer chip) having a bidirectional CA (Command Address) pin and a chip enable (CE) pin between different protocols, improve protocol compatibility.

## Claims

1. A storage device, comprising:
at least one nonvolatile memory device (13a, 13b, 13c, 13d, 13e);
a controller (11a, 11b, 11c, 11d, 11e) configured to control the at least one nonvolatile memory device (13a, 13b, 13c, 13d, 13e); and
an interface chip (12a, 12b, 12c, 12d, 12e) connected to the controller (11a, 11b, 11c, 11d, 11e) and to the at least one nonvolatile memory device (13a, 13b, 13c, 13d, 13e),
wherein the interface chip (12a, 12b, 12c, 12d, 12e) includes:
a first interface circuit (12a-1, 12b-1, 12c-1, 12d-1, 12e-1) configured to communicate with the controller (11a, 11b, 11c, 11d, 11e) according to a first interface protocol;
a second interface circuit (12a-2, 12b-2, 12c-2, 12d-2, 12e-2) configured to communicate with the at least one nonvolatile memory device (13a, 13b, 13c, 13d, 13e) according to a second interface protocol; and
a protocol converter (12a-3, 12b-3, 12c-3, 12d-3, 12e-3) configured to convert the first interface protocol to the second interface protocol or to convert the second interface protocol to the first interface protocol,
wherein the first interface circuit (12a-1, 12b-1, 12c-1, 12d-1, 12e-1) includes a first protocol conversion activation pin (SCA) connected to a ground terminal (GND), a power terminal, or a protocol conversion activation pin of the controller (11c, 11d),
wherein the second interface circuit (12a-2, 12b-2, 12c-2, 12d-1, 12e-1) includes a second protocol conversion activation pin (SCA_N) connected to a power terminal, a ground terminal (GND), or a protocol conversion activation pin of the at least one nonvolatile memory device (13d),
wherein the first interface circuit (12a-1, 12b-1, 12c-1, 12d-1, 12e-1) is configured to select one of the first interface protocol and the second interface protocol according to the voltage level of a separate command address, SCA, signal of the first protocol conversion activation pin (SCA), and
wherein the second interface circuit (12a-2, 12b-2, 12c-2, 12d-2, 12e-2) is configured to select one of the first interface protocol and the second interface protocol according to the voltage level of the second protocol conversion activation pin (SCA_N).

2. The storage device of claim 1,
wherein each of the first interface protocol and the second interface protocol is defined according to one of a JEDEC, Joint Electron Device Engineering Council, standard and an ONFI, Open NAND Flash Interface, standard, and
wherein at least one of the first interface protocol and the second interface protocol includes a command address data pin through which bidirectional communication is performed between the controller and the at least one nonvolatile memory device.

3. The storage device of claim 1 or 2,
wherein the first interface protocol is a legacy protocol, and
wherein the second interface protocol is an SCA protocol.

4. The storage device of claim 1 or 2,
wherein the first interface protocol is an SCA protocol, and
wherein the second interface protocol is a legacy protocol.

5. The storage device according to any one of claims 1 to 4, comprising:
a nonvolatile memory package (100); and
wherein the controller (200) is connected to the nonvolatile memory package (100) through a channel (CH),
wherein the nonvolatile memory package (100) includes:
a plurality of nonvolatile memory devices connected to a plurality of internal channels (ICH1, ICH2), wherein the plurality of nonvolatile memory devices comprises the at least one nonvolatile memory device; and
the interface chip configured to connect the channel (CH) to each of the plurality of internal channels (ICH1, ICH2),
wherein the interface chip includes the first interface circuit configured to communicate with the controller (200) according to the first interface protocol and the second interface circuit configured to communicate with the plurality of nonvolatile memory devices using the second interface protocol different from the first interface protocol, and
wherein at least one of the first interface circuit and the second interface circuit includes a command address data pin through which bidirectional communication is performed between the controller (200) and the plurality of nonvolatile memory devices.

## Patentansprüche

1. Eine Speichervorrichtung, umfassend:
mindestens eine nichtflüchtige Speicherungsvorrichtung (13a, 13b, 13c, 13d, 13e);
eine Steuereinheit (11a, 11b, 11c, 11d, 11e), welche derart konfiguriert ist, dass sie die mindestens eine nichtflüchtige Speicherungsvorrichtung (13a, 13b, 13c, 13d, 13e) steuert; und
einen Schnittstellenchip (12a, 12b, 12c, 12d, 12e), welcher mit der Steuereinheit (11a, 11b, 11c, 11d, 11e) und der mindestens einen nichtflüchtigen Speicherungsvorrichtung (13a, 13b, 13c, 13d, 13e) verbunden ist,
wobei der Schnittstellenchip (12a, 12b, 12c, 12d, 12e) umfasst:
eine erste Schnittstellenschaltung (12a-1, 12b-1, 12c-1, 12d-1, 12e-1), welche derart konfiguriert ist, dass sie mit der Steuereinheit (11a, 11b, 11c, 11d, 11e) gemäß einem ersten Schnittstellenprotokoll kommuniziert;
eine zweite Schnittstellenschaltung (12a-2, 12b-2, 12c-2, 12d-2, 12e-2), welche derart konfiguriert ist, dass sie mit der mindestens einen nichtflüchtigen Speicherungsvorrichtung (13a, 13b, 13c, 13d, 13e) gemäß einem zweiten Schnittstellenprotokoll kommuniziert; und
einen Protokollkonverter (12a-3, 12b-3, 12c-3, 12d-3, 12e-3), welcher derart konfiguriert ist, dass er das erste Schnittstellenprotokoll in das zweite Schnittstellenprotokoll oder das zweite Schnittstellenprotokoll in das erste Schnittstellenprotokoll umwandelt,
wobei die erste Schnittstellenschaltung (12a-1, 12b-1, 12c-1, 12d-1, 12e-1) einen ersten Protokollkonvertierungs-Aktivierungs-Pin (SCA) umfasst, welcher mit einem Masseanschluss (GND), einem Stromanschluss oder einem Protokollkonvertierungs-Aktivierungs-Pin der Steuereinheit (11c, 11d) verbunden ist,
wobei die zweite Schnittstellenschaltung (12a-2, 12b-2, 12c-2, 12d-1, 12e-1) einen zweiten Protokollkonvertierungs-Aktivierungs-Pin (SCA_N) umfasst, welcher mit einem Stromversorgungsanschluss, einem Masseanschluss (GND) oder einem Protokollkonvertierungs-Aktivierungs-Pin der mindestens einen nichtflüchtigen Speicherungsvorrichtung (13d) verbunden ist,
wobei die erste Schnittstellenschaltung (12a-1, 12b-1, 12c-1, 12d-1, 12e-1) derart konfiguriert ist, dass sie eines der ersten Schnittstellenprotokolle und das zweite Schnittstellenprotokoll entsprechend dem Spannungspegel eines separaten Befehlsadressensignals SCA des ersten Protokollkonvertierungs-Aktivierungs-Pins (SCA) auswählt, und
wobei die zweite Schnittstellenschaltung (12a-2, 12b-2, 12c-2, 12d-2, 12e-2) derart konfiguriert ist, dass sie eines von dem ersten Schnittstellenprotokoll und dem zweiten Schnittstellenprotokoll entsprechend dem Spannungspegel des zweiten Protokollkonvertierungs-Aktivierungs-Pins (SCA_N) auswählt.

2. Die Speichervorrichtung nach Anspruch 1,
wobei sowohl das erste Schnittstellenprotokoll als auch das zweite Schnittstellenprotokoll gemäß einem JEDEC-Standard, Joint Electron Device Engineering Council, oder einem ONFI-Standard, Open NAND Flash Interface, definiert sind, und
wobei mindestens eines von dem ersten Schnittstellenprotokoll und dem zweiten Schnittstellenprotokoll einen Befehlsadressdaten-Pin umfasst, über welchen eine bidirektionale Kommunikation zwischen der Steuereinheit und der mindestens einen nichtflüchtigen Speicherungsvorrichtung durchgeführt wird.

3. Die Speichervorrichtung nach Anspruch 1 oder 2,
wobei das erste Schnittstellenprotokoll ein Legacy-Protokoll ist, und
wobei das zweite Schnittstellenprotokoll ein SCA-Protokoll ist.

4. Die Speichervorrichtung nach Anspruch 1 oder 2,
wobei das erste Schnittstellenprotokoll ein SCA-Protokoll ist, und
wobei das zweite Schnittstellenprotokoll ein Legacy-Protokoll ist.

5. Die Speichervorrichtung nach einem der Ansprüche 1 bis 4, umfassend:
ein nichtflüchtiges Speicherpackage (100); und
wobei die Steuereinheit (200) über einen Kanal (CH) mit dem nichtflüchtigen Speicherpackage (100) verbunden ist,
wobei das nichtflüchtige Speicherpackage (100) umfasst:
eine Mehrzahl an nichtflüchtigen Speicherungsvorrichtungen, welche mit einer Mehrzahl an internen Kanälen (ICH1, ICH2) verbunden sind, wobei die Mehrzahl an nichtflüchtigen Speicherungsvorrichtungen die mindestens eine nichtflüchtige Speicherungsvorrichtung umfasst; und
den Schnittstellenchip, welcher derart konfiguriert ist, dass er den Kanal (CH) mit jedem der Mehrzahl an internen Kanälen (ICH1, ICH2) verbindet,
wobei der Schnittstellenchip die erste Schnittstellenschaltung umfasst, welche derart konfiguriert ist, dass sie mit der Steuereinheit (200) gemäß dem ersten Schnittstellenprotokoll zu kommuniziert, und die zweite Schnittstellenschaltung, welche derart konfiguriert ist, dass sie mit der Mehrzahl an nichtflüchtigen Speicherungsvorrichtungen unter Verwendung des zweiten Schnittstellenprotokolls, welches sich von dem ersten Schnittstellenprotokoll unterscheidet, kommuniziert, und
wobei mindestens eine von der ersten Schnittstellenschaltung und der zweiten Schnittstellenschaltung einen Befehlsadressdaten-Pin umfasst, über welchen eine bidirektionale Kommunikation zwischen der Steuereinheit (200) und der Mehrzahl an nichtflüchtigen Speicherungsvorrichtungen durchgeführt wird.

## Revendications

1. Dispositif de stockage, comprenant :
au moins un dispositif de mémoire non volatile (13a, 13b, 13c, 13d, 13e) ;
une unité de commande (11a, 11b, 11c, 11d, 11e) configurée pour commander ledit au moins un dispositif de mémoire non volatile (13a, 13b, 13c, 13d, 13e) ; et
une puce d'interface (12a, 12b, 12c, 12d, 12e) connectée à l'unité de commande (11a, 11b, 11c, 11d, 11e) et audit au moins un dispositif de mémoire non volatile (13a, 13b, 13c, 13d, 13e),
ladite puce d'interface (12a, 12b, 12c, 12d, 12e) comprenant :
un premier circuit d'interface (12a-1, 12b-1, 12c-1, 12d-1, 12e-1) configuré pour communiquer avec l'unité de commande (11a, 11b, 11c, 11d, 11e) selon un premier protocole d'interface ;
un deuxième circuit d'interface (12a-2, 12b-2, 12c-2, 12d-2, 12e-2) configuré pour communiquer avec ledit au moins un dispositif de mémoire non volatile (13a, 13b, 13c, 13d, 13e) selon un deuxième protocole d'interface ; et
un convertisseur de protocole (12a-3, 12b-3, 12c-3, 12d-3, 12e-3) configuré pour convertir le premier protocole d'interface en le deuxième protocole d'interface ou pour convertir le deuxième protocole d'interface en le premier protocole d'interface,
le premier circuit d'interface (12a-1, 12b-1, 12c-1, 12d-1, 12e-1) comprenant une première broche d'activation de conversion de protocole (SCA) connectée à une borne de masse (GND), à une borne d'alimentation ou à une broche d'activation de conversion de protocole de l'unité de commande (11c, 11d),
le deuxième circuit d'interface (12a-2, 12b-2, 12c-2, 12d-1, 12e-1) comprenant une deuxième broche d'activation de conversion de protocole (SCA_N) connectée à une borne d'alimentation, à une borne de masse (GND) ou à une broche d'activation de conversion de protocole dudit au moins un dispositif de mémoire non volatile (13d),
le premier circuit d'interface (12a-1, 12b-1, 12c-1, 12d-1, 12e-1) étant configuré pour sélectionner l'un du premier protocole d'interface et du deuxième protocole d'interface en fonction du niveau de tension d'un signal d'adresse de commande séparé de la première broche d'activation de conversion de protocole (SCA), et
le deuxième circuit d'interface (12a-2, 12b-2, 12c-2, 12d-2, 12e-2) étant configuré pour sélectionner l'un du premier protocole d'interface et du deuxième protocole d'interface en fonction du niveau de tension de la deuxième broche d'activation de conversion de protocole (SCA_N).

2. Dispositif de stockage selon la revendication 1,
dans lequel chacun du premier protocole d'interface et du deuxième protocole d'interface est défini selon l'une d'une norme JEDEC, Joint Electron Device Engineering Council, et d'une norme ONFI, Open NAND Flash Interface, et
dans lequel au moins l'un du premier protocole d'interface et du deuxième protocole d'interface comprend une broche de données d'adresse de commande à travers laquelle une communication bidirectionnelle est effectuée entre l'unité de commande et ledit au moins un dispositif de mémoire non volatile.

3. Dispositif de stockage selon la revendication 1 ou 2,
dans lequel le premier protocole d'interface est un protocole hérité, et
dans lequel le deuxième protocole d'interface est un protocole d'adresse de commande séparé.

4. Dispositif de stockage selon la revendication 1 ou 2,
dans lequel le premier protocole d'interface est un protocole d'adresse de commande séparé, et
dans lequel le deuxième protocole d'interface est un protocole hérité.

5. Dispositif de stockage selon l'une quelconque des revendications 1 à 4, comprenant :
un boîtier de mémoire non volatile (100) ; et
dans lequel l'unité de commande (200) est connectée audit boîtier de mémoire non volatile (100) par l'intermédiaire d'un canal (CH),
ledit boîtier de mémoire non volatile (100) comprenant :
une pluralité de dispositifs de mémoire non volatile connectés à une pluralité de canaux internes (ICH1, ICH2), ladite pluralité de dispositifs de mémoire non volatile comprenant ledit au moins un dispositif de mémoire non volatile ; et
la puce d'interface configurée pour connecter le canal (CH) à chacun de ladite pluralité de canaux internes (ICH1, ICH2),
ladite puce d'interface comprenant le premier circuit d'interface configuré pour communiquer avec l'unité de commande (200) selon le premier protocole d'interface et le deuxième circuit d'interface configuré pour communiquer avec ladite pluralité de dispositifs de mémoire non volatile en utilisant le deuxième protocole d'interface différent du premier protocole d'interface, et
dans lequel au moins l'un du premier circuit d'interface et du deuxième circuit d'interface comprend une broche de données d'adresse de commande à travers laquelle une communication bidirectionnelle est effectuée entre l'unité de commande (200) et ladite pluralité de dispositifs de mémoire non volatile.
